(19) Europäisches Patentamt
European Patent Office
Office européen des brevets

(11) **EP 3 916 413 B1**

(12) **EUROPÄISCHE PATENTSCHRIFT**

(45) Veröffentlichungstag und Bekanntmachung des Hinweises auf die Patenterteilung:
**24.12.2025   Patentblatt 2025/52**

(21) Anmeldenummer: **21173256.5**

(22) Anmeldetag: **11.05.2021**

(51) Internationale Patentklassifikation (IPC):
*G01R 31/58* (2020.01)      *H04L 43/0811* (2022.01)
*H04L 43/0823* (2022.01)      *G01R 31/00* (2006.01)
*G01R 31/08* (2020.01)      *G01R 31/12* (2020.01)
*H04L 43/50* (2022.01)

(52) Gemeinsame Patentklassifikation (CPC):
**G01R 31/58; H04L 43/0811; H04L 43/0847;**
G01R 31/005; G01R 31/083; G01R 31/1272;
H04L 43/50; Y04S 40/00

(54) **VORRICHTUNG UND VERFAHREN ZUR LEITUNGS- UND KABELDIAGNOSE**

DEVICE AND METHOD FOR LINE AND CABLE DIAGNOSIS

DISPOSITIF ET PROCÉDÉ DE DIAGNOSTIC DE CONDUITES ET DE CÂBLES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität:  **26.05.2020  DE 102020003143**

(43) Veröffentlichungstag der Anmeldung:
**01.12.2021   Patentblatt 2021/48**

(73) Patentinhaber: **Lapp Engineering AG 6330 Cham (CH)**

(72) Erfinder:
• **Hilsenbeck, Stefan 71144 Steinenbronn (DE)**
• **Krichel, Susanne 70569 Stuttgart (DE)**

(74) Vertreter: **Schmidt, Steffen J. Wuesthoff & Wuesthoff Patentanwälte und Rechtsanwalt PartG mbB Schweigerstrasse 2 81541 München (DE)**

(56) Entgegenhaltungen:
WO-A1-2005/036189      DE-C2- 10 112 844
US-B1- 6 177 801      US-B2- 9 154 595

**Beschreibung**

Gegenstand

Hier sind eine Vorrichtung und ein Verfahren zur Leitungs- und Kabeldiagnose offenbart. Merkmale und Eigenschaften der Vorrichtung und des Verfahrens sind in den Ansprüchen definiert; aber auch die Beschreibung und die Figuren offenbaren Charakteristika der Vorrichtung und des Verfahrens sowie deren unterschiedliche Aspekte und Zusammenhänge.

Hintergrund

Zur Aufrechterhaltung des Betriebs von Anlagen und Maschinen ist deren effiziente Wartung ein zunehmender wichtig werdender Faktor. Bei elektrischen Kabeln und Leitungen werden bisher hauptsächlich einerseits eine reaktive Wartung, also im Schadensfall der Austausch von Kabeln / Leitungen oder Verbindern, etc., und andererseits präventive Wartung eingesetzt. Bei letzterer werden Wartungsmaßnahmen und der Austausch von Verschleißteilen nach zuvor festgelegten Intervallen durchgeführt. Für die vorausschauende Wartung werden im laufenden Betrieb Kenndaten der Anlagen und Maschinen gesammelt und ausgewertet. Zur Optimierung der Kosten und der Betriebssicherheit der Anlagen und Maschinen darf die Wartungsmaßnahme weder zu früh (bedeutet hohe Kosten) noch zu spät (bedeutet Ausfall der Anlagen und Maschinen) erfolgen.

In industriellen Anlagen und Maschinen wirken teilweise sehr starke Umwelteinflüsse auf Leitungen. In bewegten und zwangsgeführten Anwendungen, z.B. in einer Energieführungskette sind Leitungen erheblichen Biege- und Walkbelastungen ausgesetzt. Bei Roboter-Anwendungen wirken zusätzlich Torsionskräfte. Auch wenn die Leitungen speziell für diese Art der Belastung ausgelegt sind, gelten sie dennoch als Verschleißteil. Typische Fehlerbilder bei Kabeln und Leitungen sind: Aderbruch, Mantel- oder Isolierungsbeschädigung, Geometrieverschiebung im Aufbau der Leitung sowie die Beschädigungen von Abschirmelementen. Diese Fehler führen dazu, dass bei Anschluss-/Steuerleitungen die Energieversorgung oder das Steuersignal unterbrochen wird; bei Datenleitungen wird die Kommunikation unterbrochen oder gestört. Ungeplante Ausfälle von Datenleitungen oder Datenkabeln durch externe Einflüsse sind in der Regel kostspielig, da sie in industriellen Maschinen und Anlagen o.ä. zu Stillständen mit entsprechenden Betriebs-/Produktionsausfällen oder auch Beschädigungen an den Maschinen und Anlagen führen können.

Stand der Technik

Aus der DE 20 2017 102 410 U1 ist bekannt, den ohmschen Leitungswiderstand eines zur eigentlichen Nutz-(Daten)leitung zusätzlichen Aderpaares in einer Messschleife zu messen und auszuwerten. Nachteilig ist hier die Genauigkeit, da sehr kleine Änderungen erfasst werden müssen. Außerdem können keine Standardleitungen verwendet werden, da ein zusätzliches, freies Aderpaar für die Messschleife benötigt wird.

Die DE 10 2013 227 051 B4 betrifft eine Messanordnung und Verfahren zur Temperaturmessung wobei mindestens ein zusätzliches Aderpaar mit unterschiedlichem Aderisolationsmaterial z.B. PVC und PE (unterschiedliche Dielektrizitätskonstante) oder unterschiedlicher Metall-Legierung der Leiter verwendet werden, um Laufzeitdifferenz und Leitungswiderstand zu überwachen.

Aus der DE 1 038 140 ist eine Ader eines Kabels mit saugfähigem Isolationsmaterial von einer Tränk-Substanz, hier Paraffin, umgeben. Bei Temperaturänderung ändert sich die Dielektrizitätskonstante. Hiermit werden Temperatur und Fehlerort durch Laufzeitmessung gegen einen Referenzleiter bestimmt. Dies erfordert einen von heutigen Kabeln erheblich abweichenden Kabelaufbau, der überdies nennenswerte Probleme bei der Zertifizierung (z.B. Brandsicherheit) bereitet. Die hier beschriebene Anordnung hat an beiden Kabelenden ein Auswertegerät installiert.

Der Anmelderin ist aus der betrieblichen Praxis, von Leuze Murrelektronik (www.leuze.com), ein Kabel mit einer Sensorleitung mit zusätzlicher Dehn-Ader bekannt, die im Querschnitt schwächer dimensioniert und anders verseilt ist als die Nutzadern. Diese Dehn-Ader soll im Betrieb zeitlich vor den Nutzadern brechen. Eine Auswerteelektronik erkennt den Aderbruch der Dehn-Ader z.B. über einen Spannungsabfall und signalisiert den Ausfall. Auch hier ist eine zusätzliche Ader erforderlich. Auch diese Anordnung hat an beiden Kabelenden ein Auswertegerät installiert.

Der Texas Instruments Chip DP83869HM Gigabit-Physical-Layer-(PHY)-Transceiver enthält PMD-Unterschichten für die Unterstützung der Ethernet-Protokolle 10BASE-TE, 100BASE-TX und 1000BASE-T. Dieser Chip enthält Überwachungsfunktionen, die anzeigen, ob der Datenverkehr funktioniert oder nicht. Dieser Chip realisiert aber keine vorausschauende Wartung, da die erfassten Parameter nicht dahingehend ausgewertet werden.

Die WO 2015/199773 A2 betrifft ein Zeit-Bereichs-Reflektometrie-(TDR) basiertes Diagnosegerät, das Anfangsdaten eines Kabels mit dessen Betriebsdaten vergleicht.

Ein Zeit-Bereichs-Reflektometer ist eine Vorrichtung zum Analysieren einer elektrischen Leitung auf Impedanz-Veränderungen, um anhand dieser Impedanz-Veränderungen damit einher gehende Anomalien zu identifizieren. Ein TDR speist einen elektrischen Energie-Impuls in eine elektrische Leitung ein. Wenn der elektrische Impuls entlang der Länge der elektrischen Leitung auf eine Impedanz-Veränderung trifft, wird ein Teil der Energie des Impulses zurück zu dem Zeit-Bereichs-Reflektometer reflektiert. Durch Auswerten, zum Beispiel, der Amplitude und der Polarität der zurück geworfenen Welle kann ein Maß der Impedanz-Veränderung bestimmt werden. Zusätzlich kann durch das Messen der Laufzeit des Impulses der Ort der Impedanz-Veränderung ebenfalls bestimmt werden. Typische Anomalien, die eine Impedanz-Veränderung verursachen können, beinhalten Spleiße, Schäden, neutrale Korrosion, gebrochene Leiter, etc., sind aber nicht darauf begrenzt.

Die US Patentanmeldung Nr. 12/820886 "Online Time Domain Reflectometer System" betrifft ein in situ zu verwendendes Zeit-Bereichs-Reflektometer das zu betreiben ist, ohne dass die elektrische Leitung außer Betrieb zu nehmen wäre.

Das Dokument US 9 154 595 B2 offenbart ein handgehaltenes Testgerät, mit dem digitale Teilnehmeranschlussleitungen (DSL, Digital Subscriber Lines) getestet werden können. Eine Testung kann dabei auf drei verschiedenen Netzwerkebenen ausgeführt werden.

Die DE 101 12 844 A1, WO 2005/036189 A1, US 6 177 801 B1, US 6,657,437 B1, EP 2 157 438 A1, DE 10, 2010 000249 A1, DE 10 2005 055429 A1, DE 10 2018 204 173 A1, DE 10 2018 204 171 A1, DE 10 2018 204 177 A1, und DE 10 2018 204 174 A1 betreffen weiteren technologischen Hintergrund.

Technisches Problem

Ausgehend hiervon soll eine robuste, effiziente und treffsichere Untersuchung und Bewertung und Ausgabe der Ausfallwahrscheinlichkeit einer Leitung bereitgestellt werden.

Vorgeschlagene Lösung

Zur Lösung dieses Problems werden Vorrichtungen oder Verfahren mit den Merkmalen bzw. Schritten der unabhängigen Ansprüche vorgeschlagen.

Eine hier vorgeschlagene Vorrichtung dient zur Diagnose einer elektrischen Leitung, um Ausfall, Verschleiß und/oder Alterung der Leitung zu prädizieren. Dabei ist die elektrische Leitung dazu vorgesehen und in der Regel in einer industriellen Maschine oder Anlage oder in einem Land- oder Luftfahrzeug verlegt, um zwei elektrische Einheiten (z.B. zentrale Steuerung und lokale Servosteuerung) zu verbinden. Die elektrische Leitung umfasst wenigstens zwei Abschnitte. Zwischen diese zwei Abschnitte ist die Vorrichtung eingesetzt. Dazu umfasst die Vorrichtung eine erste und eine zweite Schnittstelle zur Kontaktierung eines jeweiligen Endes eines der zwei Abschnitte der elektrischen Leitung. An wenigstens einer der zweiten Schnittstellen ist eine Erfassungseinrichtung mit einem digitalen Signalprozessor vorgesehen. Die wenigstens eine Erfassungseinrichtung umfasst in einer Variante ein Balun zur galvanischen Trennung der Vorrichtung von der zu überwachenden Leitung. Die Erfassungseinrichtung umfasst in weiteren Varianten stattdessen oder zusätzlich auch elektronische aktive oder passive Komponenten wie Signalverstärker, -former oder -abschwächer.

Der digitale Signalprozessor ist dazu eingerichtet und programmiert, wenigstens eine der folgenden Charakteristika in Bezug auf den jeweiligen der zwei Abschnitte der elektrischen Leitung bereitzustellen: einen Signal-Rausch-Abstand, durch den digitalen Signalprozessor auszugebende Größen wie DSP-Regelparameter zur Signal-Verbesserung, DSP Verstärkung, DSP Filterparameter, DSP Baseline, DSP Frequenz Offset, DSP Frequenz Jitter, Bit- und/oder Framefehler, und/oder Zeit-Bereichs-Reflektometrie-Daten. Des Weiteren umfasst die Vorrichtung eine elektronische Steuereinheit, die dazu eingerichtet und programmiert ist, den Betrieb des digitalen Signalprozessors (DSP) zu steuern, von dem digitalen Signalprozessor bereitgestellte Charakteristika zu empfangen und zu verarbeiten um Maß für eine Auftrittswahrscheinlichkeit eines Ausfalls, Verschleißes und/oder einer Alterung der Leitung zu erhalten, und das Maß für die Auftrittswahrscheinlichkeit des Ausfalls, Verschleißes und/oder der Alterung der Leitung auszugeben.

Eine solche Vorrichtung erlaubt eine (quasi-)kontinuierlichen Überwachung insbesondere von bewegten Datenleitungen oder Datenkabeln an oder in industriellen Maschinen und Anlagen. Aber auch unbewegte Leitungen z.B. in aggressiver Umgebung sind mit dieser Vorrichtung vorausschauend zu überwachen. Damit ist eine kontinuierliche oder Intervall-Überwachung von unter externen Einflüssen stehenden Datenleitungen oder Datenkabeln in industriellen Maschinen und Anlagen oder in Land- oder Luftfahrzeugen zu realisieren. Die Vorrichtung erlaubt auch die Überwachung einer oder mehrerer Übertragungsstrecken an beliebigen Knotenpunkten zur Vorhersage von Ausfalls-, Verschleiß- und Alterungserscheinungen der Leitung. Die Vorrichtung ist direkt an die zu überwachende Leitung angeschlossen. Eine aktive Komponente (z.B. eine Netzwerkweiche oder Verteiler) zwischen der zu überwachenden Leitung und der Vorrichtung verhindert die hier vorgeschlagene Überwachung.

Die Vorrichtung kann in Topologien mit zwei Leitungsabschnitten, zwischen die die Vorrichtung geschaltet ist, in beide Richtungen überwachen. Es ist aber auch möglich, nur einen der zwei Leitungsabschnitte zu überwachen. Ebenso ist in einer Variante die Vorrichtung nicht zwischen zwei getrennten Leitungsabschnitten angeordnet, sondern als Teilkomponente eines anderen Geräts (z.B. Rechner, Steuerung Netzwerkkomponente, oder dergl.) realisiert. In diesem Fall ist die Vorrichtung nur mit einem Leitungsabschnitt verbunden. Mit anderen Worten ist in einer Variante die Vorrichtung mit einem einzigen Leitungsabschnitt verbunden, und/oder die Vorrichtung ist in ein elektronisches Gerät wie einen Rechner, einen Netzwerkverteiler, eine Steuerung oder dergl. integriert.

Das Maß für die Auftrittswahrscheinlichkeit des Ausfalls, Verschleißes und/oder der Alterung der Leitung kann kontinuierlich oder mit wiederholten Probennahmen, auch im laufenden Betrieb der Maschine / Anlage ausgewertet werden. Das Maß für die Auftrittswahrscheinlichkeit kann als Funktion aus Messwerten der Typen Zeit-Bereichs-Reflektometrie, Signalgüte, Frame-/Bitfehlerrate und Stellglied eines digitalen Filters zur Signalrekonstruktion (Charakteristika) gebildet werden. Dabei können die unterschiedlichen Typen der Messwerte in aufeinander folgenden Messzeiträumen erfasst und ausgewertet werden. In einem ersten Messzeitraum nach der Installation der Leitung wird ein erstes Charakteristika, z.B. Signalgüte (Signal-Rausch-Verhältnis), und bei signifikanter Änderung des ersten Charakteristika in einem zweiten Messzeitraum ein zweites Charakteristika, z.B. Bitfehlerrate erfasst und ausgewertet.

So kann z.B. in einem ersten Messzeitraum nach der Installation der Leitung ein erster Typ der Messwerte Charakteristika, z.B. Signalgüte (Signal-Rausch-Verhältnis), und zum Ende des ersten Messzeitraums in einem zweiten Messzeitraum ein zweiter Typ der Messwerte, z.B. Bitfehlerrate erfasst und ausgewertet werden.

Ggf. folgen noch weitere Messzeiträume mit weiteren Messwert-Typen. Die Messzeiträume können einander zeitlich überlappen oder aneinander anschließen.

Die Festlegung der in der Vorrichtung implementierten Komponenten und Programmierung zur Erfassung und Auswertung der verwendeten Charakteristika kann abhängig von der Art der Leitung, dem Einsatzort und -zweck der Leitung, bewegte oder unbewegte Leitung, Umgebungsatmosphäre, etc. bestimmt sein. Unter kontinuierlicher oder Intervall-Überwachung bzw. -Probennahme sei hier auch verstanden, dass in Datenleitungen mit Paketdatenverkehr zwischen einzelnen Datenpaketen oder anstelle einzelner oder mehrerer Datenpakete ein oder mehrere Probensignale, zum Beispiel zur Zeit-Bereichs-Reflektometrie ausgesendet und erfasst werden um die Eigenschaften der Leitung zu erfassen und auszuwerten.

Mit einer solchen Vorrichtung und ein weiter unten dargestellten Verfahren ist eine Leitungs-und Kabeldiagnose in Anlagen und Maschinen zu realisieren. Die Vorrichtung und das Verfahren erlauben die Überwachung von elektrischen Datenübertragungsstrecken für zum Beispiel Ethernet-, Profibus-, Profinet-, CANbus-, FlexRay™-, byteflight™- Datenpakete an vorhandenen oder eingefügten Knotenpunkten. Neben Datenleitungen oder Datenkabeln können die Vorrichtung und das Verfahren auch für Anschluss-/Steuer- oder Servo-Leitungen in industriellen Maschinen und Anlagen oder in Land-, See- oder Luftfahrzeugen eingesetzt werden. Alle diese unterschiedlichen, metallisch leitenden (Kupfer-) Leitungen und -Kabel mit einer oder mehreren Adern, Aderpaaren (gleichen oder unterschiedlichen Querschnitts), Einzel- oder Sammelschirmung, Isolierschichten und/oder Ummantelungen, im Unterschied zu Lichtfaserleitungen, sind hier als "elektrische Leitung" oder "Leitung" bezeichnet.

Die IEEE Standards 802.1 und fortfolgende für LAN-Systeme bis 20Mbit/s, CSMA/CD (802.3), Token Bus (802.4) und Token Ring (802.5), IEEE 802.3u für das 100Mbit/s-Ethernet beschreiben Datenleitungen und Datenverkehr, bei denen die vorliegende Vorrichtung / das vorliegende Verfahren mit den ebenfalls beschriebenen Varianten einsetzbar ist. Dies gilt auch für Ethernet 10Base-T (IEEE 802.3 Clause 14 (ehemals IEEE 802.3i)) mit Twisted-Pair-Kabel und dem modularen Verbindungssystem RJ-45. Der Datenverkehr nutzt ein Leitungspaar zum Senden und ein weiteres Paar zum Empfang, damit ist Vollduplexbetrieb möglich. Die Topologie ist ein Sternnetz; jede der Stationen ist über eine Punkt-zu-Punkt Verbindung direkt mit einem zentralen Hub oder Switch verbunden. Auch Leitungen des Fast Ethernet 100 Mbit/s-Ethernet IEEE 802.3 Clause 23, IEEE 802.3 Clause 32, 100Base-Tx gemäß IEEE 802.3 Clause 25 (ehemals IEEE 802.3u), sowie Gigabit-Ethernet, also 1000Mbit-Ethernet, genannt 1000Base-X, 1000Base-CX, 1000Base-T (IEEE 802.3 Clause 40 (ehemals IEEE 802.3ab), 10-Gigabit-Ethernet (IEEE 802.3an) sind mit der Vorrichtung / dem Verfahren zu untersuchen. Auch Leitungen für noch schnellere Standards, z.B. das 40-Gigabit- und 100-Gigabit-Ethernet sind nach derzeitiger Kenntnis mit der Vorrichtung / dem Verfahren zu untersuchen.

Die mit der Vorrichtung / dem Verfahren gewonnenen Daten dienen zur Vorhersage von Ausfalls-, Verschleiß- und Alterungserscheinungen der Leitung.

Mit den hier vorgestellten Varianten der Vorrichtung und des Verfahrens werden die gewonnenen Daten im laufenden Anlagen-Betrieb ausgewertet. Aus diesen Daten wird ein Maß ermittelt, das zur Auslösung einer vorausschauenden Wartung der elektrischen Leitung heranziehbar ist. Die gewonnenen Daten basieren zum Beispiel auf einer oder mehreren der folgenden Kenngrößen: Laufzeit, Amplitude und kapazitive, resistive und/oder induktive, durch Zeit-Bereichs-Reflektometrie (Time-Domain-Reflectometry - TDR) gewonnene Charakteristika von Testsignalen, der Signalgüte, der Bitfehlerrate und Signalrekonstruktionsfilter-Stellwerte. Mit der Vorrichtung und dem Verfahren kann man den Zustand der Leitung bewerten und ggf. auch Schwachstellen resultierend aus Einbau oder Produktionsfehlern in der Leitung beseitigen, bevor sie zum Ausfall der Leitung mit allen negativen Konsequenzen führen. Diese Diagnose der Leitung ist für die Leitung zerstörungsfrei.

Bei hier vorgestellten Varianten der Vorrichtung und des Verfahrens können im Fall von Datenleitungen die über die Leitung versendeten Nutzdaten des laufenden Betriebs zur Gewinnung von Daten für die Ausfalls-, Verschleiß- und Alterungserscheinungen der Leitung herangezogen. Mit anderen Worten ist es in derartigen Varianten nicht erforderlich, von der Bandbreite der Leitung einen Teil zur Einspeisung von Diagnosedaten bereitzustellen. Zum einen steht so die Leitung ausschließlich für den laufenden Anlagen-Betrieb zur Verfügung. Zum anderen findet auch keine Konkurrenz-/Störung der über die Leitung versendeten Nutzdaten des laufenden Betriebs durch eingespeiste Diagnosedaten statt.

Bei anderen hier vorgestellten Varianten der Vorrichtung und des Verfahrens werden kurze Pulse (typ. 2 - 50 ns) erzeugt und in die Leitung eingekoppelt. Die Vorrichtung umfasst einen Analog/Digital-AD-Wandler, welcher für jede TDR-Messung einen Puls bereitstellt. Um das Reflexionsprofil einer Leitung vollständig darzustellen, ist eine Vielzahl von Messungen und eine entsprechend lange Messdauer erforderlich. Um die Nutz-Signal-Kommunikation auf der Leitung neben den Messungen aufrechtzuerhalten, wird nach einem oder mehreren Datenpaketen (Nutzdaten des laufenden Betriebs) nur ein oder wenige TDR-Messungen (Ergebnis: Amplitude und Laufzeit) ausgeführt. Anschließend wird die Nutz-Signal-Kommunikation wieder aufgebaut. So wird der Zustand der Leitung zwischen den / anstelle von Datenpaketen des Nutz-Signals gemessen. Dabei sind die Zeitabstände (abhängig vom jeweiligen auf der Leitung eingesetzten Protokoll der Nutzdaten) so bemessen, dass nicht mehr Datenpakete der Nutz-Signal-Kommunikation verloren gehen, als das Protokoll der Nutzdaten erlaubt. So ist sichergestellt, dass die Prozessteuerung der Maschine / Anlage innerhalb der vorgegebenen Kommunikationszykluszeit stets rechtzeitig gültige Datenpakete erhält.

Industrie-Kommunikationsstandards auf Feldbusebene wie beispielsweise Profinet, Ethercat etc. arbeiten teilweise mit konfigurierbaren Systemtaktzeiten von z.B. 62,5 $\mu$s oder 31,25 $\mu$s. Damit die Nutz-Signal-Kommunikation nicht abbricht, muss mindestens eines von mehreren (z.B. drei) Datenpaketen gültig an der Gegenstelle ankommen (z.B. Profinet). Es ist protokollseitig hinreichend Redundanz / Zeit vorgesehen für jeweils eine oder mehrere TDR-Messungen zwischen den Datenpaketen der Nutz-Signal-Kommunikation. Damit sind Steuerungs-und Regelaufgaben der Prozesssteuerung unterbrechungsfrei durchzuführen. Aus der Vielzahl diskreter TDR-Messwertpaare (Amplitude und Laufzeit) wird mittels Zeit-Bereichs-Reflektometrie ein Reflektionsprofil über die Länge des Abschnitts der Leitung zusammengefügt, und mit einem auf die gleiche Weise früher ermittelten Reflektionsprofil durch Subtrahieren und das Ergebnis Quadrieren zu einem aussagekräftigen Ergebnis verrechnet.

Bei der Inbetriebnahme der Maschine / Anlage wird in einer Variante eine Initialmessung eines Reflektionsprofils vorgenommen und abgespeichert. Dieses initiale Reflektionsprofil dient als Referenz. Dieses wird mit Reflektionsprofilen aus Messungen während des Betriebs der Leitung in der Maschine / Anlage verglichen und ausgewertet.

Werden Datenpakete in elektrische, digitale Signale gewandelt und mittels elektrischer Leitungen zu einem anderen Teilnehmer übertragen, bewirken die Kapazitäten und Induktivitäten der Leitung beim Übergang von einer logischen "0" zu einer logischen "1" und umgekehrt Pulsanstiegs- und Pulsabfallzeiten. Besonders bei großen Leitungslängen kommt an der Datensenke kein rechteckiger und somit digitaler, sondern ein eher verschliffener Signalverlauf an. Dieses analoge und mit Rauschen behaftete Signal muss gefiltert und zur anschließenden Datenverarbeitung / Befehlsgabe, erc. rekonstruiert werden. Dies geschieht üblicherweise in digitalen Signalprozessoren mit vorgeschaltetem A/D-Wandler. Eine externen Einflüssen, wie mechanischem Stress, erhöhter Temperatur oder dergl. ausgesetzte Leitung, hat verschlechterte Signalübertragungseigenschaften. Der mit der Leitung zur Messung verbundene digitale Signalprozessor erhöht dann zum Rekonstruieren und Digitalisieren der Signale in geregelter Weise die Filtertiefe. Diese höhere Filtertiefe wird bei hier vorgestellten Varianten der Vorrichtung und des Verfahrens als Charakteristikum des (verschlechterten) Zustands der Leitung ausgewertet. Außerdem steigt bei äußeren Einflüssen auf die Leitung üblicherweise die Bitfehlerrate der Nutz-Signal-Kommunikation. Aus der Bit-fehlerrate und der Gesamtanzahl ankommender Bits wird bei hier vorgestellten Varianten der Vorrichtung und des Verfahrens zusätzlich ein Wert für die Signalqualität, insbesondere ein Signal-Rausch-Verhältnis ermittelt.

In einer weiteren hier vorgestellten Variante ist die Vorrichtung als eigener Teilnehmer des Feldbusses oder des Industrie-Netzwerks konfiguriert. Die Diagnosedaten können nun über eine der zu überwachenden Leitungen zur SPS, PC, usw. übertragen werden. Eine separate Schnittstelle von der Vorrichtung zur Leitstelle entfällt hierdurch. Hierbei kann es zu geringen Laufzeiteinbußen kommen, da die Vorrichtung für die Nutz-Signal-Kommunikation nicht mehr im Durchschleifmodus arbeiten kann.

Außerdem ist in einer anderen Variante die Vorrichtung / das Verfahren in einem bereits bestehenden Teilnehmer des Feldbusses oder des Netzwerks integriert. So kann zum ein im Netzwerk ohnehin vorhandener PC oder eine Steuerung, eine Netzwerkweiche oder ein Verteiler, oder dergl. mit der hier beschriebenen Funktionalität der Vorrichtung / des Verfahrens ausgestattet sein.

Die Vorrichtung ist in einer Variante dazu eingerichtet, neben dem Ausführen der Messung an wenigstens einem der zwei Abschnitte, zwischen den zwei Abschnitten der Leitung Daten und/oder Energie von einem zum anderen der zwei Abschnitte zu transportieren. Zusätzlich oder stattdessen ist in einer Variante die Vorrichtung als eigener Teilnehmer des Bussystems oder des Netzwerks konfiguriert. Die Diagnosedaten werden in dieser Variante über eine der zu überwachenden Leitungen zur Überwachung / Auswertung / Anzeige usw. übertragen. Eine separate Schnittstelle von der Vorrichtung zur Leitstelle entfällt hierdurch.

Unter externen Einflüssen auf die Datenleitungen oder Datenkabel sind elektromagnetische Felder, mechanischer Stress, Verformungen (Biegen, Knicken, Dehnen, Stauchen, Torsion, etc.), Temperaturänderung, Feuchtigkeit, aggressive Atmosphäre, Öl-, Halogen-, oder Salzwasser-Einwirkung oder dergl.) verstanden.

Die hier vorgestellten Varianten sind im Vergleich zum Stand der Technik kostengünstiger und bieten vergleichsweise sicherere Prädiktionsergebnisse.

Das Signal-Rausch-Verhältnis, auch Störabstand oder (Signal-)Rauschabstand SRV oder S/R beziehungsweise SNR oder S/N (englisch: signal-to-noise ratio), ist ein Maß für die technische Qualität eines Nutzsignals, dem ein Rauschsignal überlagert ist. Es ist definiert als das Verhältnis der mittleren Leistung des Nutzsignals zur mittleren Rauschleistung des Rauschsignals.

Die Vorrichtung ist in einer Variante dazu eingerichtet, neben dem Ausführen der Messung an wenigstens einem der zwei Abschnitte, zwischen den zwei Abschnitten der Leitung Daten und/oder Energie von einem zum anderen der zwei Abschnitte zu transportieren.

Eine Variante der Vorrichtung ist dazu eingerichtet, auf wenigstens einem der Abschnitte der elektrischen Leitung die Auftrittswahrscheinlichkeit AWS aus wenigstens zwei während eines Messzeitraums erfassten Charakteristikaverläufen der Zeit-Bereichs-Reflektometrie, Signal-Rausch-Abstand, Bitfehlerrate und durch den digitalen Signalprozessor auszugebende Größen wie DSP-Regelparameter zur Signal-Verbesserung (Signal Conditioning), DSP Verstärkung, DSP Filterparameter, DSP Baseline, DSP Frequenz Offset, DSP Frequenz Jitter, die Auftrittswahrscheinlichkeit eines Ausfalls, Verschleißes und/oder einer Alterung der Leitung zu ermitteln, und/oder die Umgebungsbedingungen wiedergebenden Größen, wie z.B. Temperatur, Feuchte, UV- oder IR-Lichteintrag, Kenngrößen zur Korrosions-Atmosphäre wiederzugeben.

Das umfängliche Auswerten der Charakteristika(-verläufe) erlaubt, auch in individuell unterschiedlichen Einsatzbereichen und Anforderungen verschiedenster Leitungen / Leitungstypen mit einer einheitlichen Vorrichtung / Verfahrensweise zu messen. Als bei den meisten Leitungstypen relevante Charakteristika sind der Signal-Rausch-Abstand, die Parameter aus dem digitalen Signalprozessor, Bit-/Framefehler und Zeit-Bereichs-Reflektometrie. Zu den die Parametern aus dem digitalen Signalprozessor gehören die Charakteristika DSP Gain, DSP Filter, DSP Baseline, Frequenz Offset, Frequenz Jitter. Die Zeit-Bereichs-Reflektometrie-Messungen liefern insbesondere dann relevante Ergebnisse, nachdem gehäuft Bit-/ und/ oder Framefehler detektiert wurden. Die Parameter aus dem digitalen Signalprozessor DSP DSP Gain, DSP Filter, DSP Baseline, Frequenz Offset, Frequenz Jitter liefern insbesondere dann relevante Ergebnisse, nachdem das Signal-Rausch-Verhältnis sich nennenswert verschlechtert hat.

In einer Variante der Vorrichtung / des Verfahrens sind der Signal-Rausch-Abstand und Bit-/Framefehler auf der Leitung aussagekräftig. Hieraus kann zuverlässig eine Degradierung der Leitung detektiert werden. Sobald der Signal-Rausch-Abstand und Bit-/Framefehler auf der Leitung mehrmals, n-mal, (z.B. 2 < n < 20) innerhalb einer vorbestimmten Anzahl m von Messungen (10 < m < 1000) oder einer vorbestimmten Zeit (z.B x Stunden, Tage, Wochen) ein vorbestimmtes Schwellenmaß über-/unterschreiten, wird eine gestiegene Auftrittswahrscheinlichkeit AWS einer (schleichenden) Schädigung der Leitung prädiziert.

In einer Variante der Vorrichtung / des Verfahrens ist eine (schleichende) Schädigung der Leitung dadurch zu detektieren, dass zuerst der der Signal-Rausch-Abstand geringfügig aber nennenswert abnimmt, und dann Bit-/Framefehler gehäuft auftreten.

Sowohl bei analoger als auch digitaler Kommunikation ist der Signal-Rausch-Abstand (SNR) ein Maß für die Stärke des Signals relativ zum Hintergrund-Rauschen. Das Verhältnis wird als S/N oder SNR abgekürzt und normalerweise in Dezibel (dB) angegeben.

Der Signal-Rausch-Abstand S/N (in dB) oder SNR ist wie folgt definiert:

$$\frac{\text{S}}{\text{N}} = 20 \log_{10}\left(\frac{\text{Vs}}{\text{Vn}}\right)$$

wobei die ankommende Leistung des Nutzsignals Vs und die ankommende Leistung des Rauschsignals Vn ist. Je größer das Signal-Rausch-Verhältnis ist, desto störungsfreier und weniger verrauscht ist das Nutzsignal. Bei Vs = Vn ist S/N = 0. Hier ist das Signal praktisch unlesbar. Im Betriebsfall der Leitung ist Vs deutlich größer als Vn, S/N also deutlich positiv.

Zu Beginn einer Degradierung der Qualität und damit der Lebensdauer der Leitung sinkt das Signal-Rausch-Verhältnis (SNR). Die Änderung pro Zeiteinheit (z.B. Stunde, Tag, Woche, ...) ist jedoch meist sehr gering. In Varianten der Vorrichtung ist vorgesehen, in Abhängigkeit vom Aufbau der Leitung, deren Betriebsumgebungsbedingungen (Temperatur, schädliche Atmosphäre, etc.) sehr häufig, und ggf. in sehr kleinen Grenzen, das Signal-Rausch-Verhältnis zu ermitteln. In die ggf. Signalprozessor- intern ausgeführte Signal-Rausch-Abstand-(SNR) Berechnung gehen das Charakteristikum Signal-Rausch-Abstand oder Signal-Rausch-verhältnis (SNR) unter Berücksichtigung einer Leitungsdämpfung der Leitung und der Qualität einer Schirmung der Leitung ein. Somit eignet sich der SNR-Wert vor allem zu Beginn einer schleichenden Schädigung der Leitung, um das Maß für die Auftrittswahrscheinlichkeit AWS des Ausfalls, Verschleißes und/oder der Alterung der Leitung zu prädizieren.

Die Charakteristika SNR, DSP Gain und/oder DSP Filter aus dem Signalprozessor nehmen bei fortschreitender Betriebsdauer der Leitung zeitlich zuerst zu. Die Signalnachführung des Signalprozessors (Signal Conditioning, Entzerrung) sorgt jedoch dafür, dass die Datenübertragung durch die Leitung ohne Einbußen aufrechterhalten werden kann.

Dennoch kennzeichnen die Charakteristika SNR, DSP Gain und/oder DSP Filter das Maß für die Auftrittswahrscheinlichkeit des Ausfalls, Verschleißes und/oder der Alterung der Leitung.

Nach einer für die jeweilige Leitung, deren Bauart und Einsatzgebiet unterschiedlichen Zeit treten nach längerer Betriebsdauer und fortschreitender Schädigung/Alterung der Leitung zusätzlich zu oder anstelle des abnehmenden SNRs auch Bit- und Framefehler auf. Die zunehmende Bit-/Frame-fehlerrate ist für den Betriebseinsatz der (Daten-) Leitung in den Maschinen und Steuerungen kritisch, da zunehmende Bit- und Framefehler wiederholte Übertragung von Datenpakten erfordern. Dies lässt den effektiven Datendurchsatz auf der Leitung sinken.

Eine Variante der Vorrichtung ist dazu eingerichtet, auf wenigstens einem der zwei Abschnitte der elektrischen Leitung die Auftrittswahrscheinlichkeit AWS aus dem Signal-Rausch-Abstand und der Bitfehlerrate zu ermitteln, und/oder unter Berücksichtigung der Länge des jeweiligen Abschnitts zu ermitteln.

Die Vorrichtung ist in einer Variante dazu eingerichtet, den Signal-Rausch-Abstand oder das Signal-Rausch-verhältnis abhängig von Länge, Dämpfung und/oder deren Verhältnis Länge / Dämpfung des jeweiligen Abschnitts der elektrischen Leitung zu ermitteln.

Die Vorrichtung ist in einer Variante dazu eingerichtet, die durch den digitalen Signalprozessor auszugebende DSP Verstärkungs-Größe Digital Adaptive Gain Control - DAGC- abhängig von der (bekannten) Länge, Dämpfung und/oder deren Verhältnis Länge / Dämpfung des jeweiligen Abschnitts der elektrischen Leitung zu ermitteln, und/oder die durch den digitalen Signalprozessor auszugebende DSP Verstärkungs-Größe Digital Equalizer C1 Coefficient - DEQ_C1 - abhängig von der (bekannten) Länge, Dämpfung und/oder deren Verhältnis Länge / Dämpfung des jeweiligen Abschnitts der elektrischen Leitung zu ermitteln, und/oder die durch den digitalen Signalprozessor auszugebende DSP Baseline Digital Base-Line Wander Control - DBLW - des jeweiligen Abschnitts der elektrischen Leitung zu ermitteln.

Die Digital Base-Line Wander Control - DBLW - ist ein Maß für das Wandern der Baseline, also eine geringe Änderung im Mittel der Signalverlaufsgestalt. Sie zeigt sich durch eine Abschwächung oder Dämpfung des niederfrequenten Signalanteils und kann in einem gestiegenen Frequenzjitter (siehe unten) und/oder eine Verschlechterung der Bitfehlerrate - BER - resultieren.

Die Vorrichtung ist in einer Variante dazu eingerichtet, den durch den digitalen Signalprozessor auszugebenden DSP Frequenz Offset als Frequenz-Offset zu Link-Partner als langzeitige Veränderung, und/oder als Frequenz-Offset zu Link-Partner inklusive Phasenanpassung als kurzzeitige Veränderung des jeweiligen Abschnitts der elektrischen Leitung zu ermitteln.

Die Vorrichtung ist in einer Variante dazu eingerichtet, die durch den digitalen Signalprozessor auszugebende Bit-Fehler-Rate - BER - als im jeweiligen Abschnitts der elektrischen Leitung aufgetretenen Bitfehler zu ermitteln, und/oder die durch den digitalen Signalprozessor auszugebende Anzahl der Rahmenfehler - RF - des jeweiligen Abschnitts der elektrischen Leitung zu ermitteln.

Die Vorrichtung ist in einer Variante dazu eingerichtet, die durch den digitalen Signalprozessor auszugebenden Zeit-Bereichs-Reflektometrie-Daten des jeweiligen Abschnitts der elektrischen Leitung zu ermitteln, indem der digitale Signalprozessor dazu eingerichtet und programmiert ist, einen ausgehenden Puls auf den jeweiligen Abschnitt der elektrischen Leitung zu senden, und von einem reflektierten Puls Amplitude und zugehörige Laufzeit auf dem jeweiligen Abschnitt der elektrischen Leitung zu erfassen, um so erhaltene Charakteristika als Signalverlauf zu speichern und ein Reflektionsprofil über die Länge des jeweiligen Abschnitts der elektrischen Leitung zu erhalten.

Die Vorrichtung ist in einer Variante dazu eingerichtet, das Reflektionsprofil über die Länge des jeweiligen Abschnitts der elektrischen Leitung wiederholt zu ermitteln und von einem später ermittelten Reflektionsprofil ein früher ermitteltes Reflektionsprofil zu subtrahieren und das Ergebnis zu quadrieren. Als bildliche Veranschaulichung wird der Flächeninhalt der Differenz aus beiden Profilverlaufskurven bestimmt.

Die Vorrichtung ist in einer Variante dazu eingerichtet, zu den Charakteristika jeweils eine festzulegende entsprechende Anzahl, eine obere und/oder untere Grenze und ein festzulegendes entsprechendes Zeitfenster zu speichern, und das Maß für die Auftrittswahrscheinlichkeit AWS des Ausfalls, Verschleißes und/oder der Alterung der Leitung unter Berücksichtigung der Anzahl, Grenze und/oder des Zeitfensters zu ermitteln.

Die Vorrichtung ist in einer Variante dazu eingerichtet, das Charakteristikum Signal-Rausch-Abstand oder Signal-Rauschverhältnis unter Berücksichtigung einer Leitungsdämpfung der Leitung und der Qualität einer Schirmung der Leitung zu ermitteln.

Die Vorrichtung ist in einer Variante dazu eingerichtet, einzelne Charakteristika, wie etwa Signal-Rausch-Abstand / Signal-Rauschverhältnis oder Bitfehlerrate während der Ermittlung des Maßes für die Auftrittswahrscheinlichkeit AWS des Ausfalls, Verschleißes und/oder der Alterung der Leitung unterschiedlich zu gewichten, so dass zu Beginn der Messungen die Charakteristika Signal-Rausch-Abstand / Signal-Rauschverhältnis, DSP Gain oder DSP Filter um einen Faktor von etwa 1.1 - 10 stärker gewichten als die Bitfehlerrate, und dass bei Auftreten einer Bitfehlerrate in einer Ethernet-Topologie von mehr als etwa $10^{-8}$, und für Token Ring von mehr als $10^{-9}$ die Charakteristika Bitfehlerrate, DSP Gain oder DSP Filter um einen Faktor von etwa 1.1 - 10 stärker gewichten als die Charakteristika Signal-Rausch-Abstand / Signal-Rauschverhältnis, DSP Gain oder DSP Filter.

Der Abstand des jeweils vorgegebenen zulässigen Grenzwerts (Schwellenwert) zum jeweils ermittelten Charakteristikum beeinflusst das Maß für die Auftrittswahrscheinlichkeit eines Ausfalls, Verschleißes und/oder einer Alterung der Leitung. Die unterschiedliche Gewichtung beschreibt die Auswirkung einer Schwellenwertüberschreitung einzelner Charakteristika auf das Maß für die Auftrittswahrscheinlichkeit.

Die Vorrichtung ist in einer Variante dazu eingerichtet, die elektrische und/oder mechanische Betriebsdauer der Leitung zu ermitteln und in das Maß für die Auftrittswahrscheinlichkeit des Ausfalls, Verschleißes und/oder der Alterung der Leitung als dynamischen Anteil der Gewichtung einzuführen.

für 0 ... h Stunden Betrieb: Gewichtung := Gewichtung * k ; und

für h ... n Stunden Betrieb: Gewichtung := Gewichtung * $(1 + (a * e^{-b*(n-h)})$, wobei

$$1000 < h < 100000;\ 0.1 < k < 10;\ 0.1 < a < 10;\ 0.1 < b < 10$$

So können zum Beispiel lange Standzeiten der Maschine / Anlage berücksichtigt werden, in der die Leitung verbaut ist. Die Leitung altert zwar nicht mechanisch (durch Bewegung). Allerdings altert die Leitung z.B. wegen sich aus der Kunststoffummantelung verflüchtigendem Weichmacher, aggressiver oder feuchter Umgebung, Sonnenlichteinstrahlung, etc.

Die Vorrichtung ist in einer Variante dazu eingerichtet, zum Beispiel Bit- und/oder Framefehler stark zu gewichten, da solche Fehler nur bei bereits stark geschädigter Leitung auftreten. Für Bitfehler ist in einer Variante in der Vorrichtung eine für die jeweilige Leitung vorgegebene Standardeinstellung aus Erfahrungswerten gespeichert.

Die Vorrichtung ist in einer Variante dazu eingerichtet, Empfindlichkeitsprofile EP zu speichern, die abhängig von der jeweiligen Anwendungssituation der Leitung "empfindlich", "Standard" oder "unempfindlich" als Gewichtung umfassen und in einer Variante durch den Faktor k einfließen, wobei k zum Beispiel als 1.1, 1.0 und 0.9 gewählt sein kann, und einen schnelleren oder langsameren Anstieg des Maßes für die Auftrittswahrscheinlichkeit AWS bewirkt.

Die Vorrichtung ist in einer Variante dazu eingerichtet, eine Extrapolation der Indikatoren und eine Prädiktion verbleibender Schaltzyklen oder eine restlich verbleibende Betriebszeit/Lebensdauer auszugeben.

In einer Variante sind dazu in der Vorrichtung aus Messungen an entsprechenden Leitungen und unter entsprechenden Bedingungen in der Vergangenheit Degradationsverläufe gespeichert. Diese Degradationsverläufe weisen aussagekräftige Abschnitte oder Stellen auf und reichen von der Inbetriebnahme der Leitung bis zu deren Versagen. Durch Adaption dieser gespeicherten Degradationsverläufe durch entsprechende rechnerische Streckung/Stauchung, Neigung, Verschiebung um jeweilige Veränderliche in der elektronische Steuereinheit und/oder dem Signalprozessor anhand der aussagekräftigen Abschnitte oder Stellen an einen aktuellen, aber noch nicht beim Versagen der Leitung angelangten Degradationsverlauf einer Leitung wird für deren Versagen oder ein anderes aussagekräftiges Ereignis in der Lebensdauer der Leitung ein Zeitraum oder ein Zeitpunkt, und ggf. eine Wahrscheinlichkeit ermittelt, mit der dieses Versagen oder das Ereignis eintritt.

Die elektronische Steuereinheit ist in einer Variante der Vorrichtung Teil des Signalprozessors oder von diesem separat als Teil der Vorrichtung mit diesem verbunden, um die erfassten Charakteristika zu empfangen und zu verarbeiten.

Ein hier offenbartes Verfahren zur Diagnose einer elektrischen Leitung, um Ausfall, Verschleiß und/oder Alterung der Leitung zu prädizieren, wird in einer Variante mit einer Vorrichtung der oben beschriebenen Art ausgeführt. Hierbei werden von zumindest einer von zwei mit der Vorrichtung verbundenen Abschnitten der Leitung Charakteristika bereitgestellt. In einer Initialisierungsphase werden die Charakteristika / ein Degradationsverlauf der Leitung ermittelt und abgespeichert. Jeweils zugehörige Schwellenwerte sowie deren Anzahl zulässiger Über-/Unterschreitungen werden festgelegt und abgespeichert. Bei einer Zeit-Bereichs-Reflektometrie - TDR - Messung ein Referenz-Reflektionsprofil wird aufgezeichnet und gespeichert.

Eine Variante des Verfahrens zur Diagnose einer elektrischen Leitung passt die in der Initialisierungsphase ermittelten Charakteristika der Leitung in einen vorher ermittelten Referenzverlauf des Maßes für die Auftrittswahrscheinlichkeit AWS / eines Degradationsverlaufs der Leitung in einer Betriebsphase der Leitung durch entsprechende Messungen und Berechnungen ein. Dabei wird der vorher ermittelte Referenzverlauf des Maßes / des Degradationsverlaufs der Leitung ausgehend von den in der Initialisierungsphase ermittelten Charakteristika der Leitung über die Zeit extrapoliert, bis zu einem Wert eines Maßes für die Auftrittswahrscheinlichkeit des Ausfalls, Verschleißes und/oder der Alterung der Leitung, oder des Degradationsverlaufs der Leitung bei dem die verbleibende Betriebsdauer der Leitung einen vorbestimmten Wert unterschreitet oder erreicht.

Eine Variante des Verfahrens zur Diagnose einer elektrischen Leitung, um Ausfall, Verschleiß und/oder Alterung der Leitung zu prädizieren arbeitet mit einer Vorrichtung der oben beschriebenen Art, um von zumindest einem mit der Vorrichtung verbundenen Abschnitt der Leitung Charakteristika bereitzustellen. In einer Betriebsphase des Verfahrens werden die Charakteristika der Leitung ermittelt (und ggf. abgespeichert), und mit jeweils zugehörigen abgespeicherten Schwellenwerten sowie deren Anzahl abgespeicherter zulässiger Über-/Unterschreitungen, und /oder einem Zeit-Bereichs-Reflektometrie - TDR - Messprofil mit einem Referenz-Reflexionsprofil verglichen. Dies geschieht nach folgender Rechenvorschrift:

$$Char_{TDR} = \int_0^{L_l}(TRD_{akt(l)} - TDR_{ref(l)})^2 \, dl$$

Dabei ist $Char_{TDR}$ das Integral über die quadrierte Differenz der aktuellen TDR-Messung $TRD_{akt(l)}$während des Betriebs und der Referenz-TDR-Messung $TDR_{ref(l)}$ über die Länge $0 \ldots L_l$ der Leitung. Mit anderen Worten wird das ursprüngliche Reflexionsprofil von der aktuellen Kurve subtrahiert quadriert und integriert. So wird bildlich der Flächeninhalt der Differenz aus beiden Kurven bestimmt. Diese Kurven werden in einer Variante des Verfahrens für den Daten-Sende-Kanal, TD = Transmitted Data (Sendedaten), den Daten-Empfangs-Kanal RD = Received Data (Empfangsdaten) und/oder das Übersprechen (Crosstalk) der beiden Kanäle bestimmt.

Alternativ oder zusätzlich werden in einer Variante des Verfahrens an entsprechenden Leitungen und unter entsprechenden Bedingungen in der Vergangenheit gemessene Degradationsverläufe gespeichert. Diese gespeicherten Degradationsverläufe weisen aussagekräftige Abschnitte oder Stellen auf und reichen vorzugsweise von der Inbetriebnahme der Leitung bis zu deren Versagen. Durch Adaption dieser gespeicherten Degradationsverläufe mittels entsprechender rechnerischer Streckung/Stauchung, Neigung, Verschiebung um jeweilige Veränderliche anhand der aussagekräftigen Abschnitte oder Stellen an einen aktuellen, aber noch nicht beim Versagen der Leitung angelangten Degradationsverlauf einer Leitung wird für deren Versagen oder ein anderes aussagekräftiges Ereignis in der Lebensdauer der Leitung ein Zeitraum oder ein Zeitpunkt, und ggf. eine Wahrscheinlichkeit ermittelt zu dem dieses Versagen oder das Ereignis eintritt.

Zusätzlich oder anstelle der rechnerischen Streckung/ Stauchung, Neigung, Verschiebung um jeweilige Veränderliche sind auch Mustererkennungsverfahren einsetzbar, um aus aussagekräftigen Abschnitten oder Stellen eines aktuellen, aber noch nicht beim Versagen der Leitung angelangten Degradationsverlauf einer Leitung im Vergleich zu einem oder mehreren gespeicherten Degradationsverläufen eine Prädiktion eines Versagens oder eines anderen aussagekräftigen Ereignisses in der Lebensdauer der Leitung zu liefern.

In einer Variante des Verfahrens zur Diagnose einer elektrischen Leitung werden in der Betriebsphase die Charakteristika der Leitung ermittelt (und abgespeichert), indem die Charakteristika mit einer vorgegebenen Abtastrate aus der Leitung ermittelt werden, und/oder das Zeit-Bereichs-Reflektometrie - TDR - Profil als eine Aufsummierung des Fehlerquadrates des Zeit-Bereichs-Reflektometrie - TDR - Messprofils und des Referenz-Reflexionsprofils ermittelt wird.

In einer Variante des Verfahrens zur Diagnose einer elektrischen Leitung wird in der Betriebsphase bestimmt, ob das jeweilige Charakteristikum der Leitung unterhalb oberer und/ oder oberhalb unterer Schwellenwerte liegt. Im Ja-Fall wird das zeitlich nächste jeweilige Charakteristikum ermittelt, und im Nein-Fall wird ein Zähler zum Vergleich mit der jeweiligen Anzahl abgespeicherter zulässiger Über-/Unterschreitungen ggf. innerhalb einem vorgegebenen Zeitintervall, erhöht. Im Erreichensfall wird ein Alarm aktiviert/ausgegeben.

In einer Variante des Verfahrens zur Diagnose einer elektrischen Leitung wird in der Betriebsphase abhängig davon, wie oft ein Alarm aktiviert wird, die Auftrittswahrscheinlichkeit AWS des Ausfalls, Verschleißes und/oder der Alterung der Leitung als gestiegen signalisiert.

In einer Variante des Verfahrens zur Diagnose einer elektrischen Leitung wird in der Betriebsphase abhängig davon, wie oft ein Alarm aktiviert wird, die Auftrittswahrscheinlichkeit des Ausfalls, Verschleißes und/oder der Alterung der Leitung in verbleibende Schaltzyklen, restliche verbleibende Betriebszeit/Lebensdauer umgerechnet, indem die Charakteristika mit Referenz Charakteristika aus der Vergangenheit, zum Beispiel aus einem Testlauf oder anderen im Betrieb befindlichen oder gewesenen Leitungen in Bezug gesetzt wird.

<u>Kurzbeschreibung der Figuren</u>

Weitere Merkmale, Eigenschaften, Vorteile, Zweckmäßigkeiten der Vorrichtungen und der Verfahrensweisen sind der nachfolgenden Beschreibung in Verbindung mit der Zeichnung zu entnehmen. Auch mögliche Abwandlungen werden für einen Fachmann anhand der nachstehenden Beschreibung deutlich, in der auf die beigefügten Zeichnungen Bezug genommen ist. Dabei zeigen die Fig. Ausführungsformen hier erörterten Vorrichtungen.

Hierbei zeigen:

Fig. 1       eine schematische Darstellung einer Anlage, die eine Leitung mit einer Vorrichtung zur Diagnose umfasst;

Fig. 2       eine schematische Darstellung der Vorrichtung aus Fig. 1;

Fig. 3       eine schematische Darstellung einer Signalrekonstruktion mit der Vorrichtung aus Fig. 1 und 2;

Fig. 4       eine detailliertere schematische Darstellung der Anlage aus Fig. 1; und

Fig. 5,5a,5c,6      diverse Signalverläufe im Betrieb und der Auswertung der Vorrichtung.

<u>Detaillierte Beschreibung von Varianten der Vorrichtungen und der Verfahrensweisen</u>

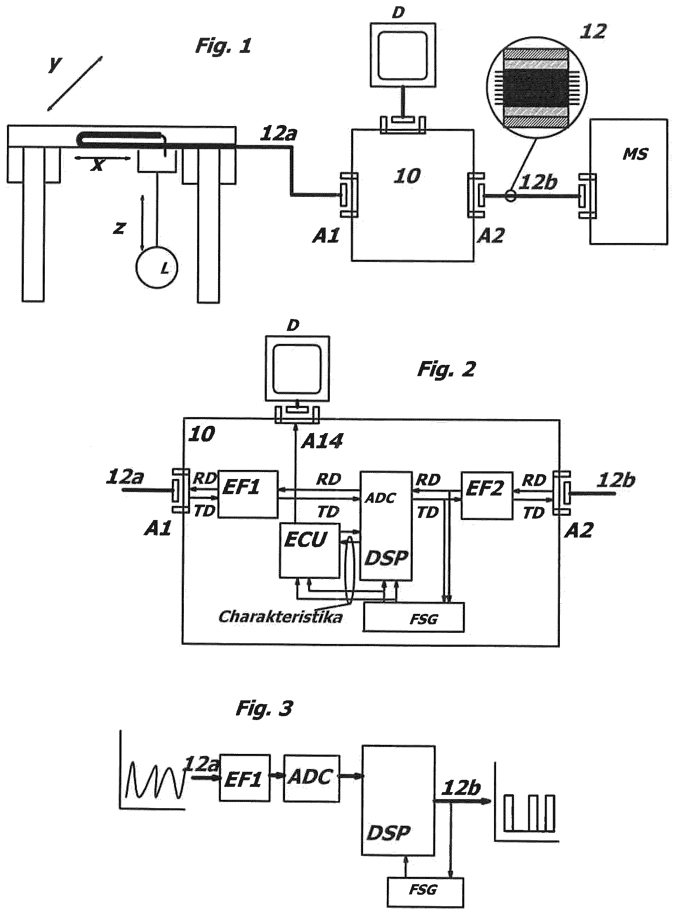

Eine in Fig. 1 veranschaulichte Situation in einer Anlage umfasst beispielhaft einen Portalkran P, der eine Last L in drei Achsen X, Y, Z transportieren kann. Der Portalkran P ist beispielhaft durch eine übergeordnete Maschinensteuerung MS zu steuern, die beispielhaft über eine elektrische (Daten-)Leitung 12 einer Ansteuerung eines Achsantriebs des Portalkrans P Steuerdaten sendet und Positionsdaten empfängt. Die elektrische Leitung 12 hat beispielhaft zwei Abschnitte 12a, 12b. Ein Abschnitt 12a der Leitung 12 ist in einer Schleppkette des Portalkrans P aufgenommen. Eine Vorrichtung 10 dient zur Diagnose einer elektrischen Leitung, um Ausfall, Verschleiß und/oder Alterung der Leitung zu prädizieren. Die Vorrichtung 10 hat eine erste und eine zweite Schnittstelle A1, A2 zur Kontaktierung eines jeweiligen Endes eines der zwei Abschnitte 12a, 12b der Leitung 12. Hier sind beispielhaft zur Kontaktierung jeweils ein 8-poliger RJ45-Stecker an den Enden der Leitung 12, und gegengleiche Buchsen gemäß den Standards der EIA/TIA 568A und 568B als erste und eine zweite Schnittstellen A1, A2 vorgesehen. In der hier gezeigten Ausgestaltung der Vorrichtung 10 ist an der ersten, mit dem ersten Abschnitt 12a der Leitung 12 verbundenen Schnittstelle A1 eine Erfassungseinrichtung EF1 mit einem digitalen Signalprozessor DSP vorgesehen.

Der auch in Fig. 2 näher veranschaulichte digitale Signalprozessor DSP ist dazu eingerichtet und programmiert, während eines jeweiligen Messzeitraums eine oder mehrere Charakteristika des jeweiligen Abschnitts 12b der Leitung 12 bereitzustellen. Diese Charakteristika umfassen: einen Signal-Rausch-Abstand, durch den digitalen Signalprozessor auszugebende Größen wie DSP-Regelparameter zur Signal-Verbesserung, DSP Verstärkung, DSP Filterparameter, DSP Baseline, DSP Frequenz Offset, DSP Frequenz Jitter, Bit- und/oder Framefehler, und Zeit-Bereichs-Reflektometrie-Daten. Die Vorrichtung 10 hat eine elektronische Steuereinheit ECU, die dazu eingerichtet und programmiert ist, den Betrieb des digitalen Signalprozessors DSP in der vorstehend beschriebenen Weise zu steuern, um von dem digitalen Signalprozessor bereitgestellte Charakteristika zu empfangen und zu verarbeiten um Maß für eine Auftrittswahrscheinlichkeit AWS eines Ausfalls, Verschleißes und/oder einer Alterung der Leitung 12 zu erhalten. Dieses erhaltene Maß für die Auftrittswahrscheinlichkeit AWS des Ausfalls, Verschleißes und/oder der Alterung der Leitung 12 gibt die elektronische Steuereinheit ECU an einer Schnittstelle A14 zur Anzeige D in für Benutzer lesbarer Weise (alphanumerisch, graphisch, audiovisuell, haptisch ...) aus.

Das Maß für die Auftrittswahrscheinlichkeit AWS des Ausfalls, Verschleißes und/oder der Alterung der Leitung 12 wird dadurch ermittelt, dass kontinuierlich oder mit wiederholten Messungen/ Probennahmen, auch im laufenden Betrieb des Portalkrans P oder einer sonstigen Anlage, als aus den Charakteristika ermittelte Funktion gebildet werden. Dabei werden die unterschiedlichen Typen der Messwerte in aufeinander folgenden Messzeiträumen erfasst und ausgewertet. So wird in einem ersten Messzeitraum nach der Installation der Leitung 12 ein erster Typ der Messwerte, hier die Signalgüte (Signal-Rausch-Verhältnis) erfasst und ausgewertet. Zum Ende des ersten Messzeitraums oder bei signifikanter Änderung des ersten Typs der Messwerte wird in einem zweiten Messzeitraum ein zweiter Typ der Messwerte, hier die Bitfehlerrate erfasst und ausgewertet. Ggf. folgen noch weitere Messzeiträume mit weiteren Messwert-Typen (z.B. Ergebnisse aus Zeit-Bereichs-Reflektometrie-Messungen). Die Messzeiträume überlappen in dieser Ausgestaltung einander zeitlich. Die Festlegung der in der Vorrichtung implementierten Komponenten und Programmierung zur Erfassung und Auswertung der verwendeten Charakteristika wird abhängig von der Art der Leitung, (Datenleitung, z.B. Ethernet, oder dergl.), dem Einsatzort und -zweck der Leitung, bewegte oder unbewegte Leitung, Umgebungsatmosphäre, etc. bestimmt. Mit einer solchen Vorrichtung und einem unten dargestellten Verfahren ist eine Leitungsdiagnose in Anlagen und Maschinen im laufenden Betrieb zu erreichen.

Die Vorrichtung 10 ist eingerichtet und bestimmt zur Übertragung / Auswertung von Daten mit einer Geschwindigkeit von 100 Mbit/s durch die Leitung zum Beispiel gemäß IEEE 802.3 Clause 25 (ehemals IEEE 802.3u), wobei ein MLT-3-Code verwendet wird, der weder gleichspannungsfrei ist, noch einen Taktgehalt hat. Diese beiden Eigenschaften werden durch die eine 4B5B-Codierung erreicht. Dabei werden 4 Nutzbits in 5-Bit-Blöcke auf der Leitung codiert. So gibt es 32 verschiedene 5-Bit-Blöcke; davon werden diejenigen 16 Blöcke für Daten verwendet, die keine langen Nullfolgen enthalten. So enthält das Signal keinen Gleichspannungsanteil im Signalverlauf, und hinreichend Taktinformation zur Taktrückgewinnung und Sender-/Empfänger-Synchronisation. Eine alternative Codierung fasst mehrere Bits zu einem Symbol zusammen und ordnet diese je einem der drei Spannungspegel (-1, 0, +1) zu. Das Verfahren wird als MLT-3 (Multi-Level Transmission) bezeichnet. Bei dieser Datenübertragung können auch TDR-Messungen mit den Nutzdaten, also ohne separat eingespeiste Testsignale, ausgeführt werden.

Wie in Fig. 3 veranschaulicht, kommt an der Schnittstelle A1 / der Erfassungseinrichtung EF1 ein Ethernet-Daten-Signal mit allmählich ansteigenden / abfallenden Flanken an. Dieses Signal wurde in die Leitung 12 als digitales Signal in der vorstehend beschriebenen Weise codiert eingespeist. Dieses, nun analoge und mit Rauschen behaftete Signal wird gefiltert und zur Datenverarbeitung rekonstruiert. Dies geschieht in dem Signalprozessor DSP mit dem vorgeschalteten A/D-Wandler ADC.

Eine externen Einflüssen ausgesetzte Leitung hat verschlechterte Signalübertragungseigenschaften. Der mit der Leitung zur Messung verbundene digitale Signalprozessor DSP der Vorrichtung 10 erhöht dann zum Rekonstruieren und Digitalisieren der Signale in geregelter Weise die Filtertiefe. Dazu hat der digitale Signalprozessor DSP ein programm-verstellbares Filterstellglied FSG. Dieses Filterstellglied ist Teil des digitalen Signalprozessors DSP oder extern zu diesem vorgesehen. Dieses Filterstellglied liefert in Abhängigkeit der Güte des in den digitalen Signalprozessor DSP eingespeisten Eingangssignals und/oder des den digitalen Signalprozessor DSP verlassende Ausgangssignal für die in dem digitalen Signalprozessor DSP implementierten digitalen Filter zur Signalkonditionierung entsprechende Filterparameter, die zum Beispiel eine höhere Filtertiefe bewirken. Diese höhere Filtertiefe ist Ausdruck der verringerten Signalqualität, welche ein Anzeichen für eine Leitungsalterung ist. Diese höhere Filtertiefe wird als Charakteristikum des (verschlechterten) Zustands der Leitung ausgewertet. Wenn während des Messzeitraums $t_{mess}$, in dem das jeweilige Charakteristikum, hier die Filtertiefe, durch den digitalen Signalprozessor DSP für eine festzulegende Anzahl von Malen (z.B. 3 mal) für den Abschnitt 12a der Leitung 12 soweit verändert, dass ein festzulegender oberer / unterer Schwellenwert OSW, USW über/unterschritten wird, detektiert dies die elektronische Steuereinheit ECU. Dies gilt in analoger Weise für die anderen vom digitalen Signalprozessor DSP ausgegebenen Parameter. Basierend hierauf wird durch die elektronische Steuereinheit ECU eine Veränderung des Maßes für die Auftrittswahrscheinlichkeit AWS des Ausfalls, Verschleißes und/ oder der Alterung der Leitung 12 berechnet, und in der Folge gibt die elektronische Steuereinheit ECU dies an der Anzeige D aus. Die oberen / unteren Schwellenwerte OSW, USW sowie andere externe Daten sind über nicht weiter veranschaulichte Eingabeschnittstellen (Tastatur, Dateitransfer, z.B. für Standarddaten zum Leitungstyp aus externer Datenbank, etc.) in den DSP und/ oder die ECU einzugeben.

Bei externen Einflüssen auf die Leitung 12 steigt in der Regel die Bitfehlerrate BER der Nutz-Signal-Kommunikation. Aus der Bitfehlerrate BER und der Gesamtanzahl ankommender Bits wird in dem Signalprozessor DSP oder der elektronischen Steuereinheit ECU zusätzlich ein Wert für die Nutz-Signalqualität in Form eines Signal-Rausch-Verhältnisses ermittelt.

In einer hier nicht weiter veranschaulichten Variante der Vorrichtung 10 ist diese als eigener Teilnehmer des Feldbusses oder des Industrie-Netzwerks konfiguriert und darin integriert. Die in der Vorrichtung 10 ermittelten Diagnosedaten werden in dieser Variante über eine der zu überwachenden Leitungen zur Maschinensteuerung oder Anzeige D übertragen. Eine separate Schnittstelle der Vorrichtung 10 zur Anzeige D oder Maschinensteuerung entfällt somit. Hierbei kann es zu geringen Laufzeiteinbußen der Nutzdaten kommen, da die Vorrichtung 10 für die Nutz-Signal-Kommunikation nicht mehr im Durchschleifmodus arbeiten kann.

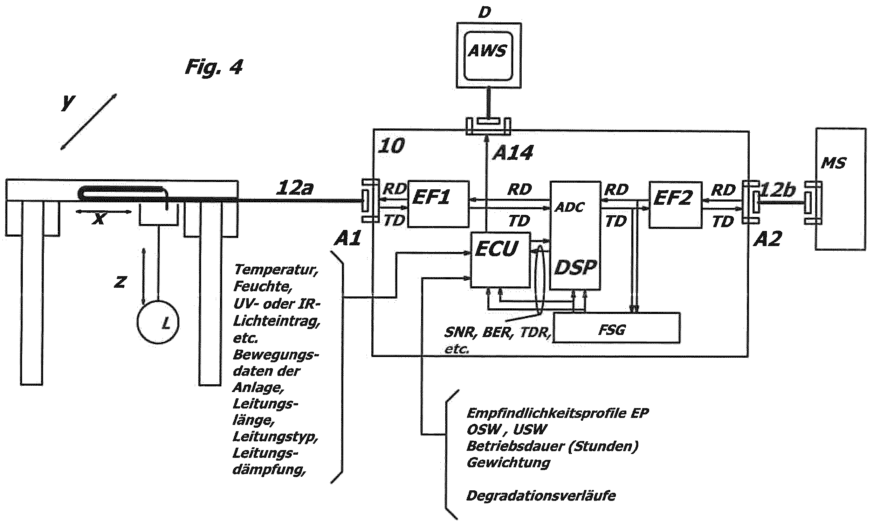

In einer in Fig. 4 veranschaulichten Variante der Vorrichtung ist diese dazu eingerichtet, auf wenigstens einem Abschnitt der elektrischen Leitung die Auftrittswahrscheinlichkeit AWS aus mindestens zwei während eines jeweiligen Messzeitraums erfassten Charakteristikaverläufen Signal-Rausch-Abstand, Bitfehlerrate, Zeit-Bereichs-Reflektometrie, und ggf. durch den digitalen Signalprozessor DSP auszugebende Größen die Auftrittswahrscheinlichkeit AWS eines Ausfalls der Leitung 12 zu ermitteln. Dabei werden in einer optionalen Ausbaustufe auch zusätzlich die Umgebungsbedingungen und/oder Betriebssituation wiedergebenden Größen, wie z.B. Temperatur, Feuchte, UV- oder IR-Lichteintrag, Kenngrößen zur Korrosions-Atmosphäre, bzw. Bewegungsdaten der Anlage (Endpositionsschalter im Mehr-Achsen-Roboter, Portalkran oder Schleppkettenaufnahme) wiedergegeben und in die Ausfallprädiktion der Leitung 12 mit einbezogen (Siehe Fig. 4).

Zu Beginn einer Degradierung der Qualität und damit der Lebensdauer der Leitung sinkt das Signal-Rausch-Verhältnis (SNR). Die Änderung pro Zeiteinheit (z.B. Stunde, Tag, Woche, ...) ist jedoch meist sehr gering. Daher ist vorgesehen, in Abhängigkeit vom Aufbau der Leitung, deren Betriebsumgebungsbedingungen, externen Einflüssen, (Temperatur, schädliche Atmosphäre, etc.) sehr häufig, und ggf. in sehr kleinen Grenzen, das Signal-Rausch-Verhältnis zu ermitteln. In die DSP-/ECU-intern ausgeführte Signal-Rausch-Abstand-(SNR)Berechnung gehen das Charakteristikum Signal-Rausch-Abstand oder Signal-Rauschverhältnis SNR unter Berücksichtigung einer Leitungsdämpfung der Leitung und der Qualität einer Schirmung der Leitung ein. Somit eignet sich der SNR-Wert vor allem zu Beginn einer schleichenden Schädigung der Leitung, um das Maß für die Auftrittswahrscheinlichkeit AWS des Ausfalls der Leitung zu prädizieren.

Das umfängliche Auswerten der Charakteristika(-verläufe) erlaubt, auch in individuell unterschiedlichen Einsatzbereichen und Anforderungen verschiedenster Leitungen / Leitungstypen mit einer einheitlichen Vorrichtung / Verfahrensweise zu messen. Als bei den meisten Leitungstypen relevante Charakteristika sind der Signal-Rausch-Abstand, die Parameter aus dem digitalen Signalprozessor DSP, Bit-/Framefehler und Zeit-Bereichs-Reflektometrie. Zu den die Parametern aus dem digitalen Signalprozessor gehören die Charakteristika DSP Gain, DSP Filter, DSP Baseline, Frequenz Offset, Frequenz Jitter. Die Zeit-Bereichs-Reflektometrie-Messungen liefern insbesondere dann relevante Ergebnisse, nachdem gehäuft Bit-/ und/ oder Framefehler detektiert werden.

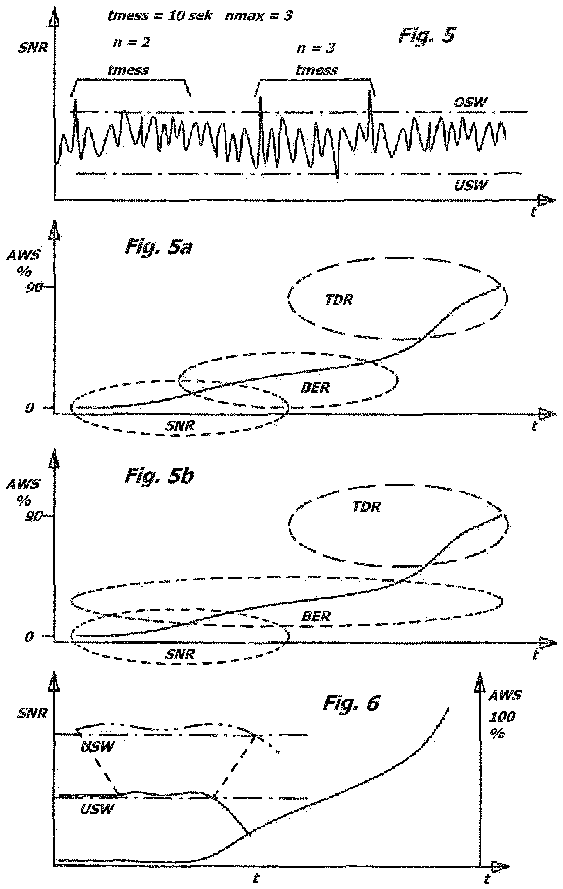

Besonders aussagekräftig sind anfänglich der Signal-Rausch-Abstand SNR, und mit zunehmender Alterung oder Schädigung der Leitung dann auch der Bit-/Framefehler BER auf der Leitung 12. Hieraus kann durch den digitalen Signalprozessor DSP zuverlässig eine Degradierung der Leitung detektiert werden. Sobald, wie in Fig. 5 veranschaulicht, diese Charakteristika SNR, BER mehrmals, $n_{max}$-mal, (2 < n < 20) innerhalb einer vorbestimmten Anzahl m von Messungen (10 < m < 1000) oder einer vorbestimmten Zeit (z.B x Sekunden, Stunden, Tage, Wochen) einen vorbestimmten oberen oder unteren Schwellenwert OSW, USW über-/unterschreiten, wird durch die Vorrichtung 10 eine gestiegene Auftrittswahrscheinlichkeit AWS einer schleichenden Schädigung der Leitung prädiziert (Siehe Fig. 5a). Insbesondere zum Ende der Lebensdauer der Leitung 12 ist dann die weiter unten im Detail beschriebene Zeit-Bereichs-Reflektometrie - TDR - Messung relevanter zur Frage, wie weit die Degradation der Leitung 12 fortgeschritten ist.

In weiteren Varianten überlappt die in Fig. 5a gezeigte zeitliche Verteilung der ermittelten Messwerte für SNR, BER und TDR zeitlich noch weiter. So erfolgt zum Beispiel in einer Variante auch von Anfang an eine parallele Erfassung der Werte für SNR und BER, und die Erfassung der Werte für BER erstreckt sich bis zum Ende hin, während sie sich parallel mit der Erfassung der Werte für TDR überlappt (Siehe Fig. 5b).

In der Vorrichtung wird eine schleichende Schädigung der Leitung dadurch detektiert, dass sich zuerst der Signal-Rausch-Abstand geringfügig aber nennenswert verschlechtert.

In den Fig. 5a, 5b ist die Auswertung anhand der ermittelten Messwerte für die Charakteristika SNR, BER und TDR veranschaulicht. In hier nicht weiter veranschaulichten Varianten sind zusätzlich oder anstelle des SNR auch die Charakteristika DSP Gain und/oder DSP Filter aus dem Signalprozessor ausgewertet, die ebenfalls bei fortschreitender Betriebsdauer der Leitung zeitlich zuerst sich deutlich verändern. Die Signalnachführung und Signalwiederherstellung in dem Signalprozessor DSP sorgt jedoch in Grenzen für eine weiterhin fehlerfreie Datenübertragung auf der Leitung. Ungeachtet der durch die Signal-Konditionierungs-Maßnahmen des digitalen Signalprozessor DSP aufrechterhaltenen Betriebsfähigkeit kennzeichnen die Charakteristika SNR, DSP Gain und/oder DSP Filter das Maß für die Auftrittswahrscheinlichkeit AWS des Ausfalls der Leitung. Sobald diese Signal-Konditionierungs-Maßnahmen des digitalen Signalprozessor DSP nicht mehr ausreichen, ist eine Betriebsfähigkeit in Form einer fehlerfreien Datenübertragung auf der Leitung nicht mehr gegeben. Dann wäre ein Austausch der Leitung unmittelbar erforderlich.

Nach längerer Betriebsdauer und fortschreitender Schädigung/Alterung der Leitung treten zunehmend Bit- und Framefehler auf. Die zunehmende Bit-/Frame-Fehlerrate BER ist für den Betriebseinsatz der (Daten-)Leitung in den Maschinen und Steuerungen kritisch, da zunehmende Bit- und Framefehler wiederholte Übertragung von Datenpaketen erfordern. Dies lässt den effektiven Datendurchsatz auf der Leitung sinken. Schließlich können betriebs- und sicherheitsrelevante Befehle / Daten / Informationen nicht mehr rechtzeitig über die Leitung kommuniziert werden und einen Defekt der Anlage oder Maschine verursachen.

Die Vorrichtung in Fig. 4 ist optional auch dazu eingerichtet, auf wenigstens einem der zwei Abschnitte der elektrischen Leitung die Auftrittswahrscheinlichkeit AWS aus den Charakteristika Signal-Rausch-Abstand SNR und Bitfehlerrate BER zu ermitteln, und dabei auch die Länge des jeweiligen Abschnitts 12a, 12b der Leitung 12 zu berücksichtigen. Wenn die erfassten SNR / BER - Werte bei bekannter Leitungslänge und -typ nicht in einem sinnvollen, erwarteten Bereich liegen, liegt ein Fehler vor, z. B. ein Kabelbinder wurde zu fest angezogen, oder die bewegte Leitung ist an einer Stelle durch die Bewegung eingeklemmt worden.

Die Vorrichtung in Fig. 4 ist optional dazu eingerichtet, die durch den digitalen Signalprozessor DSP auszugebenden Charakteristika DSP Verstärkungs-Größe Digital Adaptive Gain Control - DAGC- abhängig von der (bekannten) Länge, Dämpfung und/oder deren Verhältnis Länge / Dämpfung des jeweiligen Abschnitts der elektrischen Leitung zu ermitteln, und/oder die durch den digitalen Signalprozessor auszugebenden Charakteristika DSP Verstärkungs-Größe Digital Equalizer C1 Coefficient - DEQ_C1 - abhängig von der (bekannten) Länge, Dämpfung und/oder deren Verhältnis Länge / Dämpfung des jeweiligen Abschnitts der elektrischen Leitung 12 zu ermitteln, und/oder die durch den digitalen Signalprozessor auszugebende Charakteristika DSP Baseline Digital Base-Line Wander Control - DBLW - des jeweiligen Abschnitts der elektrischen Leitung zu ermitteln.

Die Vorrichtung in Fig. 4 ist optional dazu eingerichtet, den durch den digitalen Signalprozessor auszugebenden DSP Frequenz Offset als Frequenz-Offset zu Link-Partner als langzeitige Veränderung, und/oder als Frequenz-Offset zu Link-Partner inklusive Phasenanpassung als kurzzeitige Veränderung des jeweiligen Abschnitts der elektrischen Leitung zu ermitteln.

Die Vorrichtung in Fig. 4 ist optional dazu eingerichtet, die durch den digitalen Signalprozessor DSP auszugebenden Zeit-Bereichs-Reflektometrie-Daten des jeweiligen Abschnitts der elektrischen Leitung 12 zu ermitteln, indem der digitale Signalprozessor DSP dazu eingerichtet und programmiert ist, einen ausgehenden Puls auf den jeweiligen Abschnitt der elektrischen Leitung 12 zu senden, und von einem reflektierten Puls Amplitude und zugehörige Laufzeit auf dem jeweiligen Abschnitt der elektrischen Leitung zu erfassen, um so erhaltene Charakteristika als Signalverlauf zu speichern und ein Reflektionsprofil über die Länge des jeweiligen Abschnitts der elektrischen Leitung zu erhalten.

Die Vorrichtung in Fig. 4 ist optional dazu eingerichtet, das Reflektionsprofil über die Länge des jeweiligen Abschnitts der elektrischen Leitung wiederholt zu ermitteln und von einem später ermittelten Reflektionsprofil ein früher ermitteltes Reflektionsprofil zu subtrahieren und das Ergebnis zu quadrieren. Als bildliche Veranschaulichung wird der Flächeninhalt der Differenz aus beiden Profilverlaufskurven bestimmt.

Die Vorrichtung in Fig. 4 ist optional dazu eingerichtet, zu den Charakteristika jeweils eine festzulegende entsprechende Anzahl, eine obere und/oder untere Grenze und ein festzulegendes entsprechendes Zeitfenster zu speichern, und das Maß für die Auftrittswahrscheinlichkeit des Ausfalls, Verschleißes und/oder der Alterung der Leitung unter Berücksichtigung der Anzahl, Grenze und/oder des Zeitfensters zu ermitteln.

Die Vorrichtung in Fig. 4 ist optional dazu eingerichtet, das Charakteristikum Signal-Rausch-Abstand oder Signal-Rauschverhältnis unter Berücksichtigung einer Leitungsdämpfung der Leitung und der Qualität einer Schirmung der Leitung zu ermitteln.

Die Vorrichtung in Fig. 4 ist optional dazu eingerichtet, einzelne Charakteristika, wie etwa Signal-Rausch-Abstand / Signal-Rauschverhältnis oder Bitfehlerrate während der Ermittlung des Maßes für die Auftrittswahrscheinlichkeit AWS des Ausfalls, Verschleißes und/oder der Alterung der Leitung unterschiedlich zu gewichten, so dass zu Beginn der Messungen die Charakteristika Signal-Rausch-Abstand / Signal-Rauschverhältnis, DSP Gain oder DSP Filter um einen Faktor von etwa 1.1 - 10 stärker gewichtet ist als die Bitfehlerrate, und dass bei Auftreten einer Bitfehlerrate in einer Ethernet-Topologie von mehr als etwa $10^{-8}$ , und für Token Ring von mehr als $10^{-9}$ die Charakteristika Bitfehlerrate, DSP Gain oder DSP Filter um einen Faktor von etwa 1.1 - 10 stärker gewichtet sind als die Charakteristika Signal-Rausch-Abstand / Signal-Rauschverhältnis, DSP Gain oder DSP Filter.

Der Abstand des jeweils vorgegebenen zulässigen Grenzwerts (Schwellenwert) zum jeweils ermittelten Charakteristikum beeinflusst das Maß für die Auftrittswahrscheinlichkeit AWS eines Ausfalls, Verschleißes und/oder einer Alterung der Leitung. Die unterschiedliche Gewichtung beschreibt die Auswirkung einer Schwellenwertüberschreitung einzelner Charakteristika auf das Maß für die Auftrittswahrscheinlichkeit AWS.

Die Vorrichtung in Fig. 4 ist optional dazu eingerichtet, die elektrische und/oder mechanische Betriebsdauer der Leitung zu ermitteln und in das Maß für die Auftrittswahrscheinlichkeit AWS des Ausfalls, Verschleißes und/oder der Alterung der Leitung als dynamischen Anteil der Gewichtung einzuführen.

$$0 \ldots h \text{ Stunden Betrieb: Gewichtung} := \text{Gewichtung} * k;$$

$$h \ldots n \text{ Stunden Betrieb: Gewichtung} := \text{Gewichtung} * (1 + (a*\exp(-b * (h - n))))$$

$$0.1 < k < 10; \text{ (z.B. 1.0)}$$

$$1000 < n < 100000 \text{ (z.B. 9000)};$$

$$0.1 < a < 10 \text{ (z.B. 2.5)};$$

$$0.1 < b < 10 \text{ (z.B. 5)}$$

Diese Gewichtung wird dann mit der Auftrittswahrscheinlichkeit AWS vor deren Ausgabe multipliziert.

So können zum Beispiel lange Standzeiten der Maschine / Anlage berücksichtigt werden, in der die Leitung verbaut ist. Die Leitung altert zwar nicht mechanisch (durch Bewegung). Allerdings altert die Leitung z.B. wegen sich aus der Kunststoffummantelung verflüchtigendem Weichmacher, aggressiver oder feuchter Umgebung, Sonnenlichteinstrahlung, etc.

Alternativ oder zusätzlich kann bei bewegten Leitungen (in Robotern, Schleppketten, etc.) die mechanische Belastung durch Erfassung von Bewegungskenngrößen (Drehungswinkel der Leitungstrommel, Winkelgebersignale, Endpositionsschalter, etc.) erfasst und bei der Gewichtung berücksichtigt werden.

Die Vorrichtung in Fig. 4 ist optional dazu eingerichtet, zum Beispiel Bit- und/oder Framefehler gegenüber zum Beispiel SNR-Verringerung stark zu gewichten, da solche Fehler nur bei bereits stark geschädigter Leitung auftreten. Für Bitfehler ist in der Vorrichtung eine für die jeweilige Leitung vorgegebene Standardeinstellung aus Erfahrungswerten gespeichert.

Die Vorrichtung in Fig. 4 ist optional dazu eingerichtet, Empfindlichkeitsprofile EP zu speichern, die abhängig von der jeweiligen Anwendungssituation der Leitung "empfindlich", "Standard" oder "unempfindlich" als Gewichtung umfassen und in einer Variante durch den Faktor k einfließen, wobei k zum Beispiel als 1.1, 1.0 und 0.9 gewählt sein kann, und einen schnelleren oder langsameren Anstieg des Maßes für die Auftrittswahrscheinlichkeit AWS bewirkt.

Die Vorrichtung in Fig. 4 ist optional dazu eingerichtet, eine Extrapolation der Indikatoren und eine Prädiktion verbleibender Schaltzyklen oder eine restlich verbleibende Betriebszeit/Lebensdauer auszugeben.

Dazu sind in der Vorrichtung aus Messungen an entsprechenden Leitungen und unter entsprechenden Bedingungen in der Vergangenheit Degradationsverläufe gespeichert. Diese Degradationsverläufe sind entweder der vollständige Verlauf der Auftrittswahrscheinlichkeit über der Zeit von Inbetriebnahme bis zum Ausfall der Leitung, oder nur Abschnitte hiervon, oder diese Degradationsverläufe beziehen sich auf den zeitlichen Verlauf eines oder mehrerer Charakteristika, z.B. SNR, BER, oder TRD, oder anderer. Allen diesen Degradationsverläufen ist gemein, dass sie aussagekräftige Abschnitte oder Stellen aufweisen und reichen von der Inbetriebnahme der Leitung bis zu deren Versagen, oder eines Teils hiervon.

Durch Adaption dieser gespeicherten Degradationsverläufe durch entsprechende rechnerische Streckung/Stauchung, Neigung, Verschiebung um jeweilige Veränderliche in der elektronischen Steuereinheit und/oder dem Signalprozessor anhand der aussagekräftigen Abschnitte oder Stellen an einen aktuellen, aber noch nicht beim Versagen der Leitung angelangten Degradationsverlauf einer Leitung wird für deren Versagen oder ein anderes aussagekräftiges Ereignis in der Lebensdauer der Leitung ein Zeitraum oder ein Zeitpunkt, und ggf. eine Wahrscheinlichkeit ermittelt, zu dem dieses Versagen oder das Ereignis eintritt. So lässt sich aus einem besonders charakteristischen Verlaufs des Abfalls des SNR (strichzweipunktierte Linie in Fig. 6 dargestellt) an der zu messenden Leitung, welcher zu einem frühen Zeitpunkt in der gesamten Lebensdauer der Leitung auftritt, das voraussichtliche Ende der Lebensdauer der Leitung ermitteln. Dazu wird dieses Ereignis (Abfall des SNR) und sein zeitlicher Auftritt (z.B. 3500 Stunden nach der Inbetriebnahme der Leitung) in einen Verlauf einer Degradation (durchgehende Linie in Fig. 6 dargestellt) in einer gleichen, vorher vermessenen Leitung durch Stauchung etwa um den Faktor 2 "eingepasst". Wenn bei der vorher vermessenen Leitung dieses Ereignis (Abfall des SNR) etwa 2100 Stunden nach der Inbetriebnahme der Leitung aufgetreten ist, und diese vorher vermessene Leitung eine AWS von 100% (Totalausfall) etwa 6300 Stunden nach der Inbetriebnahme der vorher vermessenen Leitung hatte, ist bei der aktuellen Leitung ein Totalausfall nach ca. 10500 Stunden zu erwarten.

Es sei verstanden, dass diese sehr einfache Darstellung nur der Anschauung dient. In der Realität wird die früher vermessene Leitung durch viele unterschiedliche Messungen gemittelt. Außerdem werden zum Beispiel unterschiedliche Temperaturen oder Temperaturprofile, externe Einflüsse oder deren Profile etc. mit berücksichtigt. Des Weiteren ist in der obigen Darstellung nur ein aussagekräftiges Ereignis in der Lebensdauer der Leitung berücksichtigt. Dementsprechend ist die Prädiktion ungenau; insbesondere, weil das aussagekräftige Ereignis deutlich am Anfang der Lebensdauer erfasst wurde. Wenn mehrere aussagekräftige Ereignisse über die Lebensdauer der Leitung verteilt erfasst werden, lässt sich das Ende der Lebensdauer der Leitung sehr viel genauer prädizieren.

Anstatt als aussagekräftige Abschnitte oder Stellen den Abfall des SNR auszuwerten, werden in weiteren Varianten auch andere Ereignisse und deren zeitliche oder spektrale Signatur (Amplitudenverteilung) der anderen Charakteristika in der oben beschriebenen Weise ausgewertet werden.

Für den Betrieb der Vorrichtung werden zwei Phasen unterschieden: eine Initialisierungsphase und eine Betriebsphase.

Ein hier offenbartes Verfahren zur Diagnose einer elektrischen Leitung mit einer Vorrichtung der oben beschriebenen Art funktioniert wie folgt: Von zumindest einer von zwei mit der Vorrichtung verbundenen Abschnitten der Leitung werden Charakteristika bereitgestellt. In einer Initialisierungsphase werden die Charakteristika / ein Degradationsverlauf der Leitung ermittelt und abgespeichert. Jeweils zugehörige Schwellenwerte sowie deren Anzahl zulässiger Über-/Unterschreitungen werden festgelegt und abgespeichert. Bei einer Zeit-Bereichs-Reflektometrie - TDR - Messung ein Referenz-Reflektionsprofil wird aufgezeichnet und gespeichert.

Die in der Initialisierungsphase ermittelten Charakteristika der Leitung in einen vorher ermittelten Referenzverlauf des Maßes für die Auftrittswahrscheinlichkeit / eines Degradationsverlaufs der Leitung werden in einer Betriebsphase der Leitung durch entsprechende Messungen und Berechnungen eingelesen. Dabei wird der vorher ermittelte Referenzverlauf des Maßes /des Degradationsverlaufs der Leitung ausgehend von den in der Initialisierungsphase ermittelten Charakteristika der Leitung über die Zeit extrapoliert, bis zu einem Wert eines Maßes für die Auftrittswahrscheinlichkeit des Ausfalls, Verschleißes und/oder der Alterung der Leitung, oder des Degradationsverlaufs der Leitung bei dem die verbleibende Betriebsdauer der Leitung einen vorbestimmten Wert unterschreitet oder erreicht.

In einer Betriebsphase werden die Charakteristika der Leitung ermittelt (und ggf. abgespeichert), und mit jeweils zugehörigen abgespeicherten Schwellenwerten sowie deren Anzahl abgespeicherter zulässiger Über-/Unterschreitungen, und /oder einem Zeit-Bereichs-Reflektometrie - TDR - Messprofil mit einem Referenz-Reflexionsprofil verglichen. Der Vergleich geschieht mit folgender Rechenvorschrift:

$$Char_{TDR} = \int_{0}^{L_l}(TRD_{akt(l)} - TDR_{ref(l)})^2\,dl$$

Dabei ist $Char_{TDR}$ das Integral über die quadrierte Differenz der aktuellen TDR-Messung $TRD_{akt(l)}$ während des Betriebs und der Referenz-TDR-Messung $TDR_{ref(l)}$ über die Länge $0 \ldots L_l$ der Leitung. Mit anderen Worten wird das ursprüngliche Reflexionsprofil von der aktuellen Kurve subtrahiert quadriert und integriert. So wird bildlich der Flächeninhalt der Differenz aus beiden Kurven bestimmt. Diese Kurven werden für den Daten-Sende-Kanal, TD = Transmitted Data (Sendedaten), den Daten-Empfangs-Kanal RD = Received Data (Empfangsdaten) und/oder das Übersprechen (Crosstalk) der beiden Kanäle bestimmt. Das Zunehmen des Flächeninhalts der Differenz ist ein Indikator für die Degradation der Leitung.

Wenn an entsprechenden Leitungen und unter entsprechenden Bedingungen in der Vergangenheit gemessene Degradationsverläufe gespeichert verfügbar sind, können diese gespeicherten Degradationsverläufe aussagekräftige Abschnitte oder Stellen aufweisen und vorzugsweise von der Inbetriebnahme der Leitung bis zu deren Versagen reichen. Durch Adaption dieser gespeicherten Degradationsverläufe mittels entsprechender rechnerischer Streckung/Stauchung, Neigung, Verschiebung um jeweilige Veränderliche anhand der aussagekräftigen Abschnitte oder Stellen an einen aktuellen, aber noch nicht beim Versagen der Leitung angelangten Degradationsverlauf einer Leitung wird für deren Versagen oder ein anderes aussagekräftiges Ereignis in der Lebensdauer der Leitung ein Zeitraum oder ein Zeitpunkt, und ggf. eine Wahrscheinlichkeit ermittelt zu dem dieses Versagen oder das Ereignis eintritt. Zusätzlich oder anstelle der rechnerischen Streckung/ Stauchung, Neigung, Verschiebung um jeweilige Veränderliche sind auch Mustererkennungsverfahren einsetzbar, um aus aussagekräftigen Abschnitten oder Stellen eines aktuellen, aber noch nicht beim Versagen der Leitung angelangten Degradationsverlauf einer Leitung im Vergleich zu einem oder mehreren gespeicherten Degradationsverläufen eine Prädiktion eines Versagens oder eines anderen aussagekräftigen Ereignisses in der Lebensdauer der Leitung zu liefern.

In der Betriebsphase werden dann die Charakteristika der aktuell zu untersuchenden Leitung ermittelt und abgespeichert, indem die Charakteristika aus der Leitung ermittelt werden, und/oder das Zeit-Bereichs-Reflektometrie - TDR - Profil als eine Aufsummierung des Fehlerquadrates des Zeit-Bereichs-Reflektometrie - TDR - Messprofils und des Referenz-Reflexionsprofils ermittelt wird.

In der Betriebsphase wird bestimmt, ob das jeweilige Charakteristikum der Leitung unterhalb oberer und/ oder oberhalb unterer Schwellenwerte liegt. Im Ja-Fall wird das zeitlich nächste jeweilige Charakteristikum ermittelt, und im Nein-Fall wird ein Zähler zum Vergleich mit der jeweiligen Anzahl abgespeicherter zulässiger Über-/Unterschreitungen ggf. innerhalb einem vorgegebenen Zeitintervall, erhöht. Im Erreichensfall wird ein Alarm aktiviert/ausgegeben.

Zur Diagnose einer elektrischen Leitung wird in der Betriebsphase abhängig davon, wie oft ein Alarm aktiviert wird, die Auftrittswahrscheinlichkeit AWS des Ausfalls, Verschleißes und/ oder der Alterung der Leitung als gestiegen signalisiert.

Zur Diagnose einer elektrischen Leitung wird in der Betriebsphase abhängig davon, wie oft ein Alarm aktiviert wird, die Auftrittswahrscheinlichkeit AWS des Ausfalls, Verschleißes und/ oder der Alterung der Leitung in verbleibende Schaltzyklen, restliche verbleibende Betriebszeit/Lebensdauer umgerechnet, indem die Charakteristika mit Referenz Charakteristika aus der Vergangenheit, zum Beispiel aus einem Testlauf oder anderen im Betrieb befindlichen oder gewesenen Leitungen in Bezug gesetzt wird.

Die vorangehend beschriebenen Varianten der Vorrichtung, deren Aufbau- und Betriebsaspekte, sowie die Varianten der Verfahrensweise dienen lediglich dem besseren Verständnis der Struktur, der Funktionsweise und der Eigenschaften; sie schränken die Offenbarung nicht etwa auf die Ausführungsbeispiele ein. Die Fig. sind teilweise schematisch. Dabei sind wesentliche Eigenschaften und Effekte zum Teil deutlich vergrößert dargestellt, um die Funktionen, Wirkprinzipien, technischen Ausgestaltungen und Merkmale zu verdeutlichen.

Dabei kann jede Funktionsweise, jedes Prinzip, jede technische Ausgestaltung und jedes Merkmal, welches/welche in den Fig. oder im Text offenbart ist/sind, mit allen Ansprüchen, jedem Merkmal im Text und in den anderen Fig., anderen Funktionsweisen, Prinzipien, technischen Ausgestaltungen und Merkmalen, die in dieser Offenbarung enthalten sind oder sich daraus ergeben, frei und beliebig kombiniert werden, so dass alle denkbaren Kombinationen der beschriebenen Vorgehensweise zuzuordnen sind. Dabei sind auch Kombinationen zwischen allen einzelnen Ausführungen im Text, das heißt in jedem Abschnitt der Beschreibung, in den Ansprüchen und auch Kombinationen zwischen verschiedenen Varianten im Text, in den Ansprüchen und in den Fig. umfasst. Auch die Ansprüche limitieren nicht die Offenbarung und damit die Kombinationsmöglichkeiten aller aufgezeigten Merkmale untereinander. Alle offenbarten Merkmale sind explizit auch einzeln und in Kombination mit allen anderen Merkmalen hier offenbart. Die Patentansprüche geben den Gegenstand an, für den Schutz begehrt wird.

**Patentansprüche**

1. Eine Vorrichtung (10) zur Diagnose einer elektrischen Leitung (12), um Ausfall, Verschleiß und/oder Alterung der Leitung zu prädizieren, wobei die elektrische Leitung (12) dazu eingerichtet und verlegt ist, zwei elektrische Einheiten in einer industriellen Maschine oder Anlage oder in einem Land- oder Luftfahrzeug zu verbinden, und

   die elektrische Leitung (12) wenigstens zwei Abschnitte (12a, 12b) umfasst, wobei die Vorrichtung (10)

   - eine erste und eine zweite Schnittstelle (A1, A2) zur Kontaktierung eines jeweiligen Endes eines der zwei Abschnitte (12a, 12b) der elektrischen Leitung (12) umfasst,
   - eine wenigstens einer der beiden zweiten Schnittstellen (A1, A2) zugeordnete Erfassungseinrichtung (EF1, EF2) mit einem digitalen Signalprozessor (DSP) umfasst, der dazu eingerichtet und programmiert ist, wenigstens eine der folgenden Charakteristika in Bezug auf den jeweiligen wenigstens einen der zwei Abschnitte (12a, 12b) der elektrischen Leitung (12) bereitzustellen:

(i) einen Signal-Rausch-Abstand (SNR),

(ii) in dem digitalen Signalprozessor (DSP) ermittelte Größen wie DSP-Regelparameter zur Signal-Verbesserung, DSP Verstärkung, DSP Filterparameter, DSP Baseline, DSP Frequenz Offset, DSP Frequenz Jitter,

(iii) Bit- und/oder Framefehler, und/oder

(iv) Zeit-Bereichs-Reflektometrie -Daten (TDR),

- eine elektronische Steuereinheit (ECU) umfasst, die dazu eingerichtet und programmiert ist,

(i) den Betrieb des digitalen Signalprozessors (DSP) zu steuern,

(ii) von dem digitalen Signalprozessor (DSP) bereitgestellte Charakteristika zu empfangen und zu verarbeiten um ein Maß für eine Auftrittswahrscheinlichkeit AWS eines Ausfalls, Verschleißes und/oder einer Alterung der Leitung zu erhalten, und

(iii) das erhaltene Maß an einer Ausgabe (14) auszugeben, **dadurch gekennzeichnet, dass**

die Vorrichtung (10) dazu eingerichtet ist, in einem ersten Messzeitraum nach der Installation der Leitung (12) ein erstes Charakteristikum, und zum Ende des ersten Messzeitraums oder bei signifikanter Änderung des ersten Charakteristikums, in einem zweiten Messzeitraum ein zweites Charakteristikum zu erfassen und auszuwerten.

2. Die Vorrichtung nach Anspruch 1 ist dazu eingerichtet,

- auf den zwei Abschnitten (12a, 12b) der elektrischen Leitung (12) Daten und/oder Energie von einem zum anderen der zwei Abschnitte (12a, 12b) zu transportieren, und/oder nur mit einem einzigen Abschnitt verbunden ist, und/oder die Vorrichtung ist in ein elektronisches Gerät wie einen Rechner, einen Netzwerkverteiler, eine Steuerung oder dergl. integriert, und/oder

- auf wenigstens einem der zwei Abschnitte (12a, 12b) der elektrischen Leitung (12) die Auftrittswahrscheinlichkeit AWS aus mindestens zwei während eines Messzeitraums erfassten Charakteristikaverläufen der Zeit-Bereichs-Reflektometrie (TDR), Signal-Rausch-Abstand (SNR), Bitfehlerrate (BER) und durch den digitalen Signalprozessor (DSP) auszugebende Größen wie DSP-Regelparameter zur Signal-Verbesserung, DSP Verstärkung, DSP Filterparameter, DSP Baseline, DSP Frequenz Offset, DSP Frequenz Jitter, die Auftrittswahrscheinlichkeit AWS eines Ausfalls, Verschleißes und/ oder einer Alterung der Leitung (12) zu ermitteln, und/oder die Umgebungsbedingungen wiedergebenden Größen, wie z.B. Temperatur, Feuchte, UV- oder IR-Lichteintrag, Kenngrößen zur Korrosions-Atmosphäre wiederzugeben.

3. Die Vorrichtung nach einem der vorhergehenden Ansprüche ist dazu eingerichtet,

- auf wenigstens einem der zwei Abschnitte (12a, 12b) der elektrischen Leitung (12) die Auftrittswahrscheinlichkeit AWS aus mindestens zwei der in dem digitalen Signalprozessor (DSP) ermittelten Größen Charakteristika (i) Zeit-Bereichs-Reflektometrie (TDR), (ii) Signal-Rausch-Abstand (SNR), (iii) Bitfehlerrate und Stellglied-Werte eines digitalen Filters zur Signalrekonstruktion zu bestimmen, und/oder

- auf wenigstens einem der zwei Abschnitte (12a, 12b) der elektrischen Leitung (12) die Auftrittswahrscheinlichkeit AWS unter Berücksichtigung der Länge des jeweiligen Abschnitts (12a, 12b) zu ermitteln.

4. Die Vorrichtung nach einem der vorhergehenden Ansprüche ist dazu eingerichtet, dass die elektronische Steuereinheit (ECU) Teil des Signalprozessor (DSP) oder von diesem separat als Teil der Vorrichtung mit diesem verbunden ist, um die erfassten Charakteristika zu empfangen und zu verarbeiten, und/oder

- den Signal-Rausch-Abstand oder das Signal-Rauschverhältnis (SNR) abhängig von der Länge/ Dämpfung des jeweiligen Abschnitts (12a, 12b) der elektrischen Leitung (12) zu ermitteln.

5. Die Vorrichtung nach einem der vorhergehenden Ansprüche ist dazu eingerichtet,

- die durch den digitalen Signalprozessor (DSP) auszugebende DSP Verstärkungs-Größe Digital Adaptive Gain Control - DAGC- abhängig von der (bekannten) Länge/Dämpfung des jeweiligen Abschnitts (12a, 12b) der elektrischen Leitung (12) zu ermitteln, und/oder

- die durch den digitalen Signalprozessor (DSP) auszugebende DSP Verstärkungs-Größe Digital Equalizer C1 Coefficient - DEQ_C1 - abhängig von der (bekannten) Länge/Dämpfung des jeweiligen Abschnitts (12a, 12b) der elektrischen Leitung (12) zu ermitteln, und/oder

- die durch den digitalen Signalprozessor (DSP) auszugebende DSP Baseline Digital Base-Line Wander Control - DBLW - des jeweiligen Abschnitts (12a, 12b) der elektrischen Leitung (12) zu ermitteln, und/oder

- den durch den digitalen Signalprozessor (DSP) auszugebenden DSP Frequenz Offset als Frequenz-Offset zu Link-Partner als langzeitige Veränderung, und/oder als Frequenz-Offset zu Link-Partner inklusive Phasenanpassung als kurzzeitige Veränderung des jeweiligen Abschnitts (12a, 12b) der elektrischen Leitung (12) zu ermitteln, und/oder

- die durch den digitalen Signalprozessor (DSP) auszugebende Bit-Fehler-Rate - BER - als im jeweiligen Abschnitts (12a, 12b) der elektrischen Leitung (12) aufgetretenen Bitfehler zu ermitteln, und/oder

- die durch den digitalen Signalprozessor (DSP) auszugebende Anzahl der Rahmenfehler - RF - des jeweiligen Abschnitts (12a, 12b) der elektrischen Leitung (12) zu ermitteln, und/oder

- die durch den digitalen Signalprozessor (DSP) auszugebenden Zeit-Bereichs-Reflektometrie-Daten (TDR) des jeweiligen Abschnitts (12a, 12b) der elektrischen Leitung (12) zu ermit_teln, indem der digitale Signalprozessor (DSP) dazu eingerichtet und programmiert ist, einen ausgehenden Puls auf den jeweiligen Abschnitt (12a, 12b) der elektrischen Leitung (12) zu senden, und von einem reflektierten Puls eine Amplitude und eine zugehörige Laufzeit zu erfassen, um so erhaltene Charakteristika als Signalverlauf zu speichern und ein Reflexionsprofil über die Länge des jeweiligen Abschnitts (12a, 12b) der elektrischen Leitung (12) zu erhalten, und/und

- das Reflexionsprofil über die Länge des jeweiligen Abschnitts (12a, 12b) der elektrischen Leitung (12) wiederholt zu ermitteln und von einem später ermittelten Reflexionsprofil ein früher ermitteltes Reflexionsprofil zu subtrahieren und das Ergebnis zu quadrieren.

6. Die Vorrichtung nach einem der vorhergehenden Ansprüche ist dazu eingerichtet,

- zu den Charakteristika jeweils eine festzulegende entsprechende Anzahl, eine obere und/ oder untere Grenze und ein festzulegendes entsprechendes Zeitfenster zu speichern, und das Maß für die Auftrittswahrscheinlichkeit AWS des Ausfalls, Verschleißes und/oder der Alterung der Leitung unter Berücksichtigung der Anzahl, Grenze und/oder des Zeitfensters zu ermitteln, und/oder

- das Charakteristikum Signal-Rausch-Abstand oder Signal-Rauschverhältnis (SNR) unter Berücksichtigung der Leitungsdämpfung und der Qualität der Schirmung zu ermitteln, und/oder

- einzelne Charakteristika, wie etwa Signal-Rausch-Abstand / Signal-Rauschverhältnis (SNR) oder Bit-Fehlerrate (BER) während der Ermittlung des Maßes für die Auftrittswahrscheinlichkeit AWS des Ausfalls, Verschleißes und/oder der Alterung der Leitung unterschiedlich zu gewichten.

7. Die Vorrichtung nach dem vorhergehenden Anspruch ist dazu eingerichtet, dass

- zu Beginn der Messungen in einer Betriebsphase die Charakteristika Signal-Rausch-Abstand / Signal-Rausch-verhältnis (SNR), DSP Gain oder DSP Filter um einen Faktor von etwa 1.1 - 10 stärker gewichtet sind als die Bitfehlerrate (BER), und/oder dass

- bei Auftreten einer Bitfehlerrate (BER) in einer Ethernet-Verbindung von mehr als einer ersten definierten Größe und bei Auftreten einer Bitfehlerrate (BER) in einer Token Ring-Verbindung von mehr als einer zweiten definierten Größe die Charakteristika Bitfehlerrate (BER), DSP Gain oder DSP Filter um einen Faktor von etwa 1.1 - 10 stärker gewichtet sind als die Charakteristika Signal-Rausch-Abstand / Signal-Rausch-verhältnis (SNR), DSP Gain oder DSP Filter, und/oder dass

zu Beginn der Messung in einer Betriebsphase die Charakteristika Signal-Rausch-Abstand / Signal-Rauschverhältnis (SNR), DSP Gain oder DSP Filter etwa gleich gewichtet sind wie die Bitfehlerrate (BER), und/oder dass bei Auftreten einer Bitfehlerrate (BER) in einer Ethernet-Verbindung von mehr als einer ersten definierten Größe und bei Auftreten einer Bitfehlerrate (BER) in einer Token Ring-Verbindung von mehr als einer zweiten definierten Größe die Charakteristika Bitfehlerrate (BER), DSP Gain oder DSP Filter um einen Faktor von etwa 0 - 10 stärker gewichtet sind als die Charakteristika Signal-Rausch-Abstand / Signal-Rauschverhältnis (SNR), DSP Gain oder DSP Filter.

8. Die Vorrichtung nach dem vorhergehenden Anspruch ist dazu eingerichtet, in einer Initialisierungsphase die elektrische und/oder mechanische Betriebsdauer der Leitung zu erfassen und in der Betriebsphase in die Ermittlung des Maßes für die Auftrittswahrscheinlichkeit AWS des Ausfalls, Verschleißes und/oder der Alterung der Leitung als dynamischen Anteil der Gewichtung einzuführen, wobei

für 0 ... h Stunden Betrieb: Gewichtung := Gewichtung * k ; und
für h ... n Stunden Betrieb: Gewichtung := Gewichtung * $(1 + (a * e^{-b*(n-h)})$, wobei

$$1000 < h < 100000; 0.1 < k < 10; 0.1 < a < 10; 0.1 < b < 10$$

9. Die Vorrichtung nach dem vorhergehenden Anspruch ist dazu eingerichtet,

   - Bit- und/oder Framefehler stark zu gewichten, wobei für Bitfehler in der Vorrichtung eine auf die jeweilige Leitung vorgegebene Standardeinstellung aus Erfahrungswerten gespeichert ist, und/oder
   - Empfindlichkeitsprofile (EP) zu speichern, die abhängig von der jeweiligen Anwendungssituation der Leitung "empfindlich", "Standard" oder "unempfindlich" als Gewichtung umfassen, und in einer Variante durch den Faktor k einfließen.

10. Verfahren zur Diagnose einer elektrischen Leitung (12), um Ausfall, Verschleiß und/oder Alterung der Leitung zu prädizieren, wobei mit einer Vorrichtung gemäß einem der vorherigen Ansprüche von zumindest einer von zwei mit der Vorrichtung (10) verbundenen Abschnitten (12a, 12b) Charakteristika bereitgestellt werden, und

    - in einer Initialisierungsphase die Charakteristika der Leitung ermittelt und abgespeichert werden, und
    - jeweils zugehörige Schwellenwerte sowie deren Anzahl zulässiger Über-/Unterschreitungen festgelegt und abgespeichert werden, und /oder bei der Zeit-Bereichs-Reflektometrie - TDR - Messung ein Referenz-Reflexionsprofil aufgezeichnet und gespeichert wird, **dadurch gekennzeichnet, dass**

    in einem ersten Messzeitraum nach der Installation der Leitung (12) ein erstes Charakteristikum, und zum Ende des ersten Messzeitraums oder bei signifikanter Änderung des ersten Charakteristikums in einem zweiten Messzeitraum ein zweites Charakteristikum erfasst und ausgewertet wird.

11. Verfahren zur Diagnose einer elektrischen Leitung (12) nach dem vorhergehenden Anspruch, wobei

    - die in der Initialisierungsphase ermittelten Charakteristika der Leitung in einen vorher ermittelten Referenzverlauf des Maßes für die Auftrittswahrscheinlichkeit AWS eingepasst werden, und
    - der vorher ermittelte Referenzverlauf des Maßes ausgehend von den in der Initialisierungsphase ermittelten Charakteristika der Leitung über die Zeit extrapoliert wird, bis zu einem Wert eines Maßes für die Auftrittswahrscheinlichkeit AWS des Ausfalls, Verschleißes und/ oder der Alterung der Leitung, bei dem die verbleibende Betriebsdauer der Leitung einen vorbestimmten Wert unterschreitet.

12. Verfahren nach einem der vorhergehenden Verfahrensansprüche zur Diagnose einer elektrischen Leitung (12), um Ausfall, Verschleiß und/oder Alterung der Leitung zu prädizieren, wobei mit einer Vorrichtung der oben beschriebenen Art von zumindest einer von zwei mit der Vorrichtung (10) verbundenen Abschnitten (12a, 12b) Charakteristika bereitgestellt werden, und

    - in einer Betriebsphase die Charakteristika der Leitung ermittelt werden, und
    - mit jeweils zugehörigen abgespeicherten Schwellenwerten sowie deren Anzahl abgespeicherter zulässiger Über-/Unterschreitungen, und /oder einem Zeit-Bereichs-Reflektometrie - TDR - Messprofil mit einem Referenz-Reflexionsprofil in der Weise verglichen wird, dass

$$Char_{TDR} = \int_0^{L_l} \left( TRD_{akt(l)} - TDR_{ref(l)} \right)^2 dl,$$

    wobei *Char*$_{TDR}$ das Integral über die quadrierte Differenz der aktuellen TDR-Messung *TRD*$^{akt(l)}$ während des Betriebs und der Referenz-TDR-Messung *TDR*$_{ref(l)}$ über die Länge 0 ... $L_l$ der Leitung ist, wobei
    - diese Kurve

        -- für das Aderpaar des Daten-Sende-Kanals, TD = Transmitted Data /Sendedaten,
        -- das Aderpaar des Daten-Empfangs-Kanal RD = Received Data /Empfangsdaten,
        -- und/oder für das Übersprechen / Crosstalk der beiden Kanäle bestimmt wird, und/oder

    - in der Betriebsphase die Charakteristika der Leitung ermittelt werden, indem die Charakteristika mit einer vorgegebenen Abtastrate aus der Leitung (12) ermittelt werden, und/oder das Zeit-Bereichs-Reflektometrie - TDR - Profil als eine Aufsummierung des Fehlerquadrates des Zeit-Bereichs-Reflektometrie - TDR - Messprofils und des Referenz-Reflexionsprofils ermittelt wird, und/oder

**EP 3 916 413 B1**

- in der Betriebsphase bestimmt wird, ob das jeweilige Charakteristikum der Leitung unterhalb oberer und/oder oberhalb unterer Schwellenwerte liegt, und
- im Ja-Fall das zeitlich nächste jeweilige Charakteristikum ermittelt wird, und
- im Nein-Fall ein Zähler zum Vergleich mit der jeweiligen Anzahl abgespeicherter zulässiger Über-/Unterschreitungen ggf. innerhalb einem vorgegebenen Zeitintervall, erhöht wird, und im Erreichensfall ein Alarm aktiviert wird.

13. Verfahren nach einem der vorhergehenden Verfahrensansprüche zur Diagnose einer elektrischen Leitung (12), wobei

- in der Betriebsphase abhängig davon, wie oft ein Alarm aktiviert wird, die Auftrittswahrscheinlichkeit AWS des Ausfalls, Verschleißes und/oder der Alterung der Leitung als gestiegen signalisiert wird, und/oder
- in der Betriebsphase abhängig davon, wie oft ein Alarm aktiviert wird, die Auftrittswahrscheinlichkeit AWS des Ausfalls, Verschleißes und/oder der Alterung der Leitung in verbleibende Schaltzyklen, restliche verbleibende Betriebszeit/Lebensdauer umgerechnet wird, indem die Charakteristika mit Referenz-Charakteristika aus der Vergangenheit, aus einem oder mehreren Testläufen oder anderen im Betrieb befindlichen oder gewesenen Leitungen in Bezug gesetzt wird.

**Claims**

1. A device (10) for diagnosing an electrical conductor (12) to predict failure, wear, and/or aging of the conductor, wherein

the electrical conductor (12) is arranged and laid to connect two electrical units in an industrial machine or plant or in an land or aircraft vehicle, and the electrical conductor (12) comprises at least two sections (12a, 12b), wherein the device (10) comprises

- a first and a second interface (A1, A2) for contacting a respective end of one of the two sections (12a, 12b) of the electrical conductor (12),
- a detection device (EF1, EF2) associated with at least one of the two second interfaces (A1, A2) and comprising a digital signal processor (DSP) which is designed and programmed to provide at least one of the following characteristics in relation to the respective at least one of the two sections (12a, 12b) of the electrical conductor (12):

(i) a signal-to-noise ratio (SNR),
(ii) quantities determined in the digital signal processor (DSP), such as DSP control parameters for signal enhancement, DSP gain, DSP filter parameters, DSP baseline, DSP frequency offset, DSP frequency jitter,
(iii) bit and/or frame errors, and/or
(iv) time domain reflectometry (TDR) data,

- an electronic control unit (ECU) configured and programmed to

(i) control the operation of the digital signal processor (DSP),
(ii) receive and process characteristics provided by the digital signal processor (DSP) to obtain a measure of a probability of occurrence AWS of failure, wear, and/or aging of the conductor, and
(iii) outputting the obtained measure to an output (14), **characterized in that** the device (10) is designed to detect and evaluate a first characteristic in a first measurement period after installation of the conductor (12) and, at the end of the first measurement period or in the event of a significant change in the first characteristic, a second characteristic in a second measurement period.

2. The device according to claim 1 is set up to

- transport data and/or energy from one of the two sections (12a, 12b) of the electrical conductor (12) to the other of the two sections (12a, 12b), and/or is connected to only a single section, and/or the device is integrated into an electronic device such as a computer, a network distributor, a control system, or the like, and/or
- on at least one of the two sections (12a, 12b) of the electrical conductor (12), the occurrence probability AWS is calculated from at least two characteristic curves of the time domain reflectometry (TDR), signal-to-noise ratio (SNR), bit error rate (BER) and variables to be output by the digital signal processor (DSP), such as DSP control parameters for signal improvement, DSP amplification, DSP filter parameters, DSP baseline, DSP frequency offset, DSP frequency jitter, the probability of occurrence AWS of a failure, wear and/or aging of the conductor (12), and/or variables reflecting the environmental conditions, such as temperature, humidity, UV or IR light input, parameters for the corrosive atmosphere.

3. The device according to one of the preceding claims is set up to

- on at least one of the two sections (12a, 12b) of the electrical conductor (12), to determine the probability of occurrence AWS from at least two of the variables determined in the digital signal processor (DSP), namely characteristics (i) time domain reflectometry (TDR), (ii) signal-to-noise ratio (SNR), (iii) bit error rate, and actuator values of a digital filter for signal reconstruction, and/or
- determining the probability of occurrence AWS on at least one of the two sections (12a, 12b) of the electrical conductor (12), taking into account the length of the respective section (12a, 12b).

4. The device according to one of the preceding claims is set up so that the electronic control unit (ECU) is part of the signal processor (DSP) or is connected to it separately as part of the device in order to receive and process the detected characteristics, and/or

- to determine the signal-to-noise ratio (SNR) depending on the length/attenuation of the respective section (12a, 12b) of the electrical conductor (12).

5. The device according to one of the preceding claims is set up to

- determine the DSP gain value Digital Adaptive Gain Control - DAGC - to be output by the digital signal processor (DSP) depending on the (known) length/attenuation of the respective section (12a, 12b) of the electrical conductor (12), and/or
- to determine the DSP gain value Digital Equalizer C1 Coefficient (DEQ_C1) to be output by the digital signal processor (DSP) depending on the (known) length/attenuation of the respective section (12a, 12b) of the electrical conductor (12), and/or
- determining the DSP baseline Digital Base-Conductor Wander Control - DBLW - of the respective section (12a, 12b) of the electrical conductor (12) to be output by the digital signal processor (DSP), and/or
- to determine the DSP frequency offset to be output by the digital signal processor (DSP) as a frequency offset to the link partner as a long-term change, and/or as a frequency offset to the link partner including phase adjustment as a short-term change of the respective section (12a, 12b) of the electrical conductor (12), and/or
- determine the bit error rate (BER) to be output by the digital signal processor (DSP) as bit errors occurring in the respective section (12a, 12b) of the electrical conductor (12), and/or
- determining the number of frame errors (RF) of the respective section (12a, 12b) of the electrical conductor (12) to be output by the digital signal processor (DSP), and/or
- determining the time domain reflectometry data (TDR) of the respective section (12a, 12b) of the electrical conductor (12) to be output by the digital signal processor (DSP), wherein the digital signal processor (DSP) is set up and programmed for this purpose to send an outgoing pulse to the respective section (12a, 12b) of the electrical conductor (12) and detecting an amplitude and an associated transit time from a reflected pulse, thereby storing the characteristics obtained as a signal waveform and obtaining a reflection profile over the length of the respective section (12a, 12b) of the electrical conductor (12), and/or
- repeatedly determining the reflection profile over the length of the respective section (12a, 12b) of the electrical conductor (12) and subtracting an earlier determined reflection profile from a later determined reflection profile and squaring the result.

6. The device according to one of the preceding claims is set up to

- store a corresponding number to be specified, an upper and/or lower limit, and a corresponding time window to be specified for each characteristic, and determine the measure of the probability of occurrence AWS of failure, wear, and/or aging of the conductor, taking into account the number, limit, and/or time window, and/or
- to determine the characteristic signal-to-noise ratio (SNR) taking into account the conductor attenuation and the quality of the shielding, and/or
- weighting individual characteristics, such as signal-to-noise ratio (SNR) or bit error rate (BER), differently during the determination of the measure of the probability of occurrence (AWS) of failure, wear and/or aging of the conductor.

7. The device according to the preceding claim is set up so that

- at the start of measurements in an operating phase, the characteristics signal-to-noise ratio (SNR), DSP gain, or DSP filter are weighted more heavily than the bit error rate (BER) by a factor of approximately 1.1 - 10, and/or that
- when a bit error rate (BER) greater than a first defined value occurs in an Ethernet connection and when a bit error rate (BER) greater than a second defined value occurs in a token ring connection, the characteristics bit error rate (BER), DSP gain, or DSP filter are weighted by a factor of approximately 1.1 - 10 more heavily than the characteristics signal-to-noise ratio (SNR), DSP gain, or DSP filter, and/or that at the start of the measurement in an operating phase, the characteristics signal-to-noise ratio (SNR), DSP gain or DSP filter are weighted approximately equally to the bit error rate (BER), and/or that when a bit error rate (BER) greater than a first defined value occurs in an Ethernet connection and when a bit error rate (BER) greater than a second defined value occurs in a token ring connection, the characteristics bit error rate (BER), DSP gain, or DSP filter are weighted by a factor of approximately 0 - 10 more heavily than the characteristics signal-to-noise ratio (SNR), DSP gain, or DSP filter.

8. The device according to the preceding claim is designed to record the electrical and/or mechanical operating time of the conductor in an initialization phase and to introduce it into the determination of the measure for the probability of occurrence AWS of failure, wear and tear and/or aging of the conductor as a dynamic component of the weighting in the operating phase, wherein

for 0 ... h hours of operation: weighting := weighting * k ; and
for h ... n ours of operation: weighting := weighting * $(1 + (a * e^{-b*(n-h)})$where

$$1000 < h < 100000; 0.1 < k < 10; 0.1 < a < 10; 0.1 < b < 10$$

9. The device according to the preceding claim is set up to

- heavily weight bit and/or frame errors, wherein a standard setting based on empirical values specified for the respective conductor is stored in the device for bit errors, and/or
- to store sensitivity profiles (EP) which, depending on the respective application situation of the conductor, comprise "sensitive," "standard," or "insensitive" as weighting and, in one variant, are incorporated by the factor k.

10. Method for diagnosing an electrical conductor (12) in order to predict failure, wear and/or aging of the conductor, wherein a device according to one of the previous claims provides characteristics of at least one of two sections (12a, 12b) connected to the device (10), and

- in an initialization phase, the characteristics of the conductor are determined and stored, and
- respective associated threshold values and their number of permissible exceed-ances/undershootings are determined and stored, and/or in the time domain reflectometry - TDR - measurement, a reference reflection profile is recorded and stored, and in a first measurement period after installation of the conductor (12), a first characteristic is recorded and evaluated, and at the end of the first measurement period or in the event of a significant change in the first characteristic, a second characteristic is recorded and evaluated in a second measurement period.

11. Method for diagnosing an electrical conductor (12) according to the preceding claim, wherein

- the characteristics of the conductor determined in the initialization phase are fitted into a previously determined reference curve of the measure for the occurrence probability AWS, and
- the previously determined reference curve of the measure is extrapolated over time based on the characteristics of the conductor determined in the initialization phase, up to a value of a measure for the probability of occurrence AWS of failure, wear, and/or aging of the conductor, at which the remaining operating life of the conductor falls below a predetermined value.

12. Method according to one of the preceding method claims for diagnosing an electrical conductor (12) in order to predict failure, wear, and/or aging of the conductor, wherein characteristics are provided with a device of the type described above of at least one of two sections (12a, 12b) connected to the device (10), and

- in an operating phase, the characteristics of the conductor are determined, and
- with respective associated stored threshold values and their number of stored permissible overruns/underruns, and/or a time domain reflectometry (TDR) measurement profile with a reference reflection profile in such a way that

$$Char_{TDR} = \int_0^{L_l} \left(TRD_{akt(l)} - TDR_{ref(l)}\right)^2 dl,$$

where $Char_{TDR}$ is the integral over the squared difference between the current TDR measurement $TRD_{akt(l)}$ during operation and the reference TDR measurement $TDR_{ref(l)}$ over the length 0 ... $L_l$ of the conductor, where
- this curve

-- for the wire pair of the data transmission channel, TD = Transmitted Data,
-- the wire pair of the data reception channel RD = Received Data,
-- and/or for the crosstalk between the two channels is determined, and/or

- in the operating phase, the characteristics of the conductor are determined by determining the characteristics from the conductor (12) at a predetermined sampling rate, and/or the time domain reflectometry - TDR - profile is determined as a summation of the error square of the time domain reflectometry - TDR - measurement profile and the reference reflection profile, and/or
- during the operating phase, it is determined whether the respective characteristic of the conductor is below upper and/or above lower threshold values, and
- if yes, the next respective characteristic is determined, and
- if no, a counter is incremented for comparison with the respective number of stored permissible overruns/underruns, if applicable within a specified time interval, and an alarm is activated when this number is reached.

**13.** Method according to one of the preceding method claims for diagnosing an electrical conductor (12), wherein

- during the operating phase, depending on how often an alarm is activated, the probability of occurrence AWS of failure, wear, and/or aging of the conductor is signaled as increased, and/or
- in the operating phase, depending on how often an alarm is activated, the probability of occurrence AWS of failure, wear and/or aging of the conductor is converted into remaining switching cycles, remaining operating time/service life by relating the characteristics to reference characteristics from the past, from one or more test runs, or from other conductors that are or have been in operation.

**Revendications**

**1.** Un dispositif (10) destiné au diagnostic d'un conducteur électrique (12) afin de prédire la défaillance, l'usure et/ou le vieillissement du conducteur,

le conducteur électrique (12) est conçu et installé pour relier deux unités électriques dans une machine ou une installation industrielle ou dans un véhicule terrestre ou aérien, et
le conducteur électrique (12) comprend au moins deux sections (12a, 12b),
le dispositif (10) comprends

- une première et une deuxième interfaces (A1, A2) pour établir le contact avec une extrémité respective de l'une des deux sections (12a, 12b) du conducteur électrique (12),
- un dispositif de détection (EF1, EF2) associé à au moins l'une des deux deuxièmes interfaces (A1, A2) et comprenant un processeur de signal numérique (DSP) qui est conçu et programmé pour fournir au moins l'une des caractéristiques suivantes en rapport avec au moins l'une des deux sections (12a, 12b) du conducteur électrique (12) :

(i) un rapport signal/bruit (SNR),
(ii) des grandeurs déterminées dans le processeur de signal numérique (DSP), telles que des paramètres de réglage DSP pour l'amélioration du signal, le gain DSP, les paramètres de filtre DSP, le conducteur de base DSP, le décalage de fréquence DSP, la gigue de fréquence DSP,

(iii) des erreurs de bits et/ou de trames, et/ou

(iv) des données de réflectométrie dans le domaine temporel (TDR),

- une unité de commande électronique (ECU) configurée et programmée pour

(i) commander le fonctionnement du processeur de signal numérique (DSP),

(ii) recevoir et traiter les caractéristiques fournies par le processeur de signal numérique (DSP) afin d'obtenir une mesure de la probabilité d'occurrence AWS d'une défaillance, d'une usure et/ou d'un vieillissement du conducteur, et

(iii) émettre la mesure obtenue vers une sortie (14), **caractérisé en ce que** le dispositif (10) est conçu pour enregistrer et évaluer une première caractéristique pendant une première période de mesure après l'installation de la conduite (12) et, à la fin de la première période de mesure ou en cas de modification significative de la première caractéristique, une deuxième caractéristique pendant une deuxième période de mesure.

2. Le dispositif selon la revendication 1 est conçu pour

- transporter des données et/ou de l'énergie d'une section (12a, 12b) à l'autre des deux sections (12a, 12b) du conducteur électrique (12), et/ou est connecté à une seule section, et/ou le dispositif est intégré dans un appareil électronique tel qu'un ordinateur, un répartiteur de réseau, une commande ou similaire, et/ou

- sur au moins l'une des deux sections (12a, 12b) du conducteur électrique (12), la probabilité d'occurrence AWS à partir d'au moins deux courbes caractéristiques enregistrées pendant une période de mesure de la réflectométrie dans le domaine temporel (TDR), du rapport signal/bruit (SNR), taux d'erreur binaire (BER) et des grandeurs à émettre par le processeur de signal numérique (DSP) telles que les paramètres de régulation DSP pour l'amélioration du signal, l'amplification DSP, les paramètres de filtre DSP, le conducteur de base DSP, le décalage de fréquence DSP, gigue de fréquence DSP, la probabilité d'occurrence AWS d'une défaillance, d'une usure et/ou d'un vieillissement du conducteur (12), et/ou les grandeurs reflétant les conditions environ-nementales, telles que la température, l'humidité, l'entrée de lumière UV ou IR, les paramètres caractéristiques de l'atmosphère corrosive.

3. Le dispositif selon l'une des revendications précédentes est conçu pour

- sur au moins l'une des deux sections (12a, 12b) du conducteur électrique (12), la probabilité d'occurrence AWS à partir d'au moins deux des grandeurs déterminées dans le processeur de signal numérique (DSP) caractéristiques (i) réflectométrie dans le domaine temporel (TDR), (ii) rapport signal/bruit (SNR), (iii) taux d'erreur binaire et valeurs d'actionneur d'un filtre numérique pour la reconstruction du signal, et/ou

- sur au moins l'une des deux sections (12a, 12b) du conducteur électrique (12), déterminer la probabilité d'occurrence AWS en tenant compte de la longueur de la section respective (12a, 12b).

4. Le dispositif selon l'une des revendications précédentes est conçu de telle sorte que l'unité de commande électronique (ECU) fasse partie du processeur de signal (DSP) ou soit reliée à celui-ci séparément en tant que partie du dispositif afin de recevoir et de traiter les caractéristiques enregistrées, et/ou

- déterminer le rapport signal/bruit ou le rapport signal/bruit (SNR) en fonction de la longueur/de l'atténuation de la section respective (12a, 12b) du conducteur électrique (12).

5. Le dispositif selon l'une des revendications précédentes est conçu pour

- déterminer la valeur d'amplification DSP Digital Adaptive Gain Control - DAGC - à délivrer par le processeur de signal numérique (DSP) en fonction de la longueur/de l'atténuation (connue) de la section respective (12a, 12b) du conducteur électrique (12), et/ou

- déterminer la grandeur d'amplification DSP à émettre par le processeur de signal numérique (DSP), Digital Equalizer C1 Coefficient - DEQ_C1 -, en fonction de la longueur/de l'atténuation (connue) de la section respective (12a, 12b) du conducteur électrique (12), et/ou

- déterminer le conducteur de base DSP à émettre par le processeur de signal numérique (DSP) Digital Base Line Wander Control - DBLW - de la section respective (12a, 12b) du conducteur électrique (12), et/ou

- déterminer le décalage de fréquence DSP à émettre par le processeur de signal numérique (DSP) en tant que décalage de fréquence vers le partenaire de liaison en tant que modification à long terme, et/ou en tant que décalage de fréquence vers le partenaire de liaison, y compris l'ajustement de phase, en tant que modification à court terme de la section respective (12a, 12b) du conducteur électrique (12), et/ou

- déterminer le taux d'erreurs sur les bits (BER) à émettre par le processeur de signal numérique (DSP) en tant qu'erreurs sur les bits survenues dans la section respective (12a, 12b) du conducteur électrique (12), et/ou

- déterminer le nombre d'erreurs de trame (RF) de la section respective (12a, 12b) du conducteur électrique (12) à émettre par le processeur de signal numérique (DSP), et/ou

- déterminer les données de réflectométrie dans le domaine temporel (TDR) de la section respective (12a, 12b) du conducteur électrique (12) à émettre par le processeur de signal numérique (DSP), le processeur de signal numérique (DSP) étant configuré et programmé à cet effet pour envoyer une impulsion sortante à la section respective (12a, 12b) du conducteur électrique (12) et en détectant une amplitude et un temps de propagation associé à partir d'une impulsion réfléchie, afin de stocker les caractéristiques ainsi obtenues sous forme de courbe de signal et d'obtenir un profil de réflexion sur la longueur de la section respective (12a, 12b) du conducteur électrique (12), et/ou

- déterminer de manière répétée le profil de réflexion sur la longueur de la section respective (12a, 12b) du conducteur électrique (12) et soustraire un profil de réflexion déterminé antérieurement d'un profil de réflexion déterminé ultérieurement et élever le résultat au carré.

6. Le dispositif selon l'une des revendications précédentes est conçu pour

- enregistrer pour chaque caractéristique un nombre correspondant à déterminer, une limite supérieure et/ou une limite inférieure et une fenêtre temporelle correspondante à déterminer, et déterminer la mesure de la probabilité d'occurrence AWS de la défaillance, de l'usure et/ou du vieillissement du conducteur en tenant compte du nombre, de la limite et/ou de la fenêtre temporelle, et/ou

- déterminer la caractéristique rapport signal/bruit ou rapport signal/bruit (SNR) en tenant compte de l'atténuation du conducteur et de la qualité du blindage, et/ou

- pondérer différemment certaines caractéristiques, telles que le rapport signal/bruit (SNR) ou le taux d'erreur binaire (BER), lors de la détermination de la mesure de la probabilité d'occurrence AWS de la défaillance, de l'usure et/ou du vieillissement du conducteur.

7. Le dispositif selon la revendication précédente est conçu de telle sorte que

- au début des mesures dans une phase de fonctionnement, les caractéristiques rapport signal/bruit (SNR), gain DSP ou filtre DSP soient pondérées par un facteur d'environ 1,1 à 10 plus fortement que le taux d'erreur sur les bits (BER), et/ou que

- en cas d'apparition d'un taux d'erreur sur les bits (BER) dans une connexion Ethernet supérieur à une première valeur définie et en cas d'apparition d'un taux d'erreur sur les bits (BER) dans une connexion Token Ring supérieur à une deuxième valeur définie, les caractéristiques taux d'erreur sur les bits (BER), gain DSP ou filtre DSP sont pondérées par un facteur d'environ 1,1 à 10 plus fortement que les caractéristiques rapport signal/bruit (SNR), gain DSP ou filtre DSP, et/ou que au début de la mesure dans une phase de fonctionnement, les caractéristiques rapport signal/bruit (SNR), gain DSP ou filtre DSP sont pondérées à peu près de la même manière que le taux d'erreur sur les bits (BER), et/ou qu'en cas d'apparition d'un taux d'erreur sur les bits (BER) dans une connexion Ethernet supérieur à une première grandeur définie et en cas d'apparition d'un taux d'erreur sur les bits (BER) dans une connexion en anneau à jeton supérieur à une deuxième grandeur définie, les caractéristiques taux d'erreur sur les bits (BER), gain DSP ou filtre DSP sont pondérées par un facteur d'environ 0 à 10 plus fortement que les caractéristiques rapport signal/bruit (SNR), gain DSP ou filtre DSP.

8. Le dispositif selon la revendication précédente est conçu pour enregistrer, dans une phase d'initialisation, la durée de fonctionnement électrique et/ou mécanique du conducteur et, dans la phase de fonctionnement, pour introduire dans la détermination de la mesure de la probabilité d'occurrence AWS de la défaillance, de l'usure et/ou du vieillissement du conducteur en tant que partie dynamique de la pondération, pour 0 ... h heures de fonctionnement: pondération := pondération * k ; et

pour h ... n heures de fonctionnement:

pondération := pondération * $(1 + (a * e^{-b*(n-h)})$, où

$$1000 < h < 100000; 0.1 < k < 10; 0.1 < a < 10; 0.1 < b < 10$$

9. **Le dispositif** selon la revendication précédente est conçu pour

- pondérer fortement les erreurs de bits et/ou de trames, un réglage standard prédéfini pour le conducteur concernée à partir de valeurs empiriques étant enregistré dans le dispositif pour les erreurs de bits, et/ou
- de stocker des profils de sensibilité (EP) qui, en fonction de la situation d'application respective du conducteur, comprennent « sensible », « standard » ou « insensible » comme pondération et sont pris en compte dans une variante par le facteur k.

10. Un procédé de diagnostic d'une ligne électrique (12) afin de prédire la défaillance, l'usure et/ou le vieillissement du conducteur, dans lequel, à l'aide d'un dispositif selon l'une des revendications précédentes, des caractéristiques sont fournies à partir d'au moins l'une des deux sections (12a, 12b) connectées au dispositif (10), et

- dans une phase d'initialisation, les caractéristiques du conducteur sont déterminées et enregistrées , et
- les valeurs seuils associées respectives ainsi que leur nombre de dépassements supérieurs/inférieurs admissibles sont déterminés et enregistrés, et/ou lors de la réflectométrie dans le domaine temporel - TDR -, un profil de réflexion de référence est enregistré et sauvegardé, et au cours d'une première période de mesure après l'installation du conducteur (12), une première caractéristique est enregistrée et évaluée, et à la fin de la première période de mesure ou en cas de modification significative de la première caractéristique, une deuxième caractéristique est enregistrée et évaluée au cours d'une deuxième période de mesure.

11. Le procédé de diagnostic d'une ligne électrique (12) selon la revendication précédente, dans lequel

- les caractéristiques du conducteur déterminées lors de la phase d'initialisation sont ajustées à une courbe de référence préalablement déterminée de la mesure de la probabilité d'occurrence AWS, et
- la courbe de référence préalablement déterminée de la mesure est extrapolée dans le temps à partir des caractéristiques du conducteur déterminées lors de la phase d'initialisation, jusqu'à une valeur d'une mesure de la probabilité d'occurrence AWS de la défaillance, de l'usure et/ou du vieillissement du conducteur, pour laquelle la durée de fonctionnement restante du conducteur est inférieure à une valeur prédéterminée.

12. Le procédé selon l'une des revendications de procédé précédentes pour diagnostiquer une ligne électrique (12) afin de prédire la défaillance, l'usure et/ou le vieillissement du conducteur, dans lequel, à l'aide d'un dispositif du type décrit ci-dessus, les caractéristiques d'au moins l'une des deux sections (12a, 12b) connectées au dispositif (10) sont fournies, et

- dans une phase de fonctionnement, les caractéristiques du conducteur sont déterminées et
- elles sont comparées à des valeurs seuils enregistrées associées ainsi qu'à leur nombre de dépassements/- sous-dépassements admissibles enregistrés, et/ou à un profil de mesure par réflectométrie dans le domaine temporel (TDR) avec un profil de réflexion de référence, de telle sorte que

$$Char_{TDR} = \int_0^{L_l} \left( TRD_{akt(l)} - TDR_{ref(l)} \right)^2 dl,$$

où $Char_{TDR}$ est l'intégrale sur la différence au carré de la mesure TDR actuelle $TRD^{akt(l)}$ pendant le fonctionnement et de la mesure TDR de référence $TDR_{ref(l)}$ sur la longueur 0 ... $L_l$ du conducteur, où
- cette courbe

-- pour la paire de fils du canal de transmission de données, TD = Transmitted Data /Données envoyées,
-- la paire de fils du canal de réception de données RD = données reçues,
-- et/ou pour la diaphonie / crosstalk des deux canaux sont déterminées, et/ou

- pendant la phase de fonctionnement, les caractéristiques du conducteur sont déterminées en déterminant les caractéristiques à partir du conducteur (12) à une fréquence d'échantillonnage prédéfinie, et/ou le profil de réflectométrie dans le domaine temporel - TDR - est déterminé comme une somme du carré de l'erreur du profil de mesure de la réflectométrie dans le domaine temporel - TDR - et du profil de réflexion de référence, et/ou
- pendant la phase de fonctionnement, il est déterminé si la caractéristique respective du conducteur est inférieure aux valeurs seuils supérieures et/ou supérieure aux valeurs seuils inférieures, et
- dans le cas affirmatif, la caractéristique respective suivante dans le temps est déterminée, et
- dans le cas contraire, un compteur est incrémenté pour comparaison avec le nombre respectif de dépassements/sous-dépassements admissibles enregistrés, le cas échéant dans un intervalle de temps prédéfini, et une alarme est activée en cas d'atteinte.

13. Le procédé selon l'une des revendications précédentes pour le diagnostic d'une ligne électrique (12), dans lequel

- pendant la phase de fonctionnement, en fonction de la fréquence d'activation d'une alarme, la probabilité d'occurrence AWS de la défaillance, de l'usure et/ou du vieillissement du conducteur est signalée comme étant accrue, et/ou
- pendant la phase de fonctionnement, en fonction de la fréquence à laquelle une alarme est activée, la probabilité d'occurrence AWS de la défaillance, de l' usure et/ou du vieillissement du conducteur est convertie en cycles de commutation restants, en durée de fonctionnement/durée de vie restante, en mettant en relation les caractéristiques avec des caractéristiques de référence issues du passé, d'un ou plusieurs essais ou d'autres conducteurs en service ou ayant été en service.

Fig. 1

Fig. 2

Fig. 3

Fig. 4

Temperatur,
Feuchte,
UV- oder IR-
Lichteintrag,
etc.
Bewegungsdaten der
Anlage,
Leitungslänge,
Leitungstyp,
Leitungsdämpfung,

Empfindlichkeitsprofile EP
OSW , USW
Betriebsdauer (Stunden)
Gewichtung

Degradationsverläufe

SNR, BER, TDR,
etc.

Fig. 5

Fig. 5a

Fig. 5b

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 202017102410 U1
- DE 102013227051 B4
- DE 1038140
- WO 2015199773 A2
- US 12820886 B
- US 9154595 B2
- DE 10112844 A1
- WO 2005036189 A1
- US 6177801 B1

- US 6657437 B1
- EP 2157438 A1
- DE 102010000249 A1
- DE 102005055429 A1
- DE 102018204173 A1
- DE 102018204171 A1
- DE 102018204177 A1
- DE 102018204174 A1